# EUROPEAN PATENT APPLICATION

(11) **EP 4 301 111 A1**
(43) Date of publication of application: **03.01.2024**
(21) Application number: 23180776.9
(22) Date of filing: 21.06.2023
(51) Int. Cl.: H10K 50/844, H10K 77/10, H10K 71/80

(54) **MOTHER SUBSTRATE INCLUDING A PLURALITY OF DISPLAY DEVICES AND METHOD FOR FABRICATING A DISPLAY DEVICE**

(30) Priority: 27.06.2022 KR 20220078136
(71) Applicant: Samsung Display Co., Ltd., Yongin-si, Gyeonggi-do 17113 (KR)
(72) Inventor: YI, Yun Won, Yongin-si (KR); SONG, Su Jin, Yongin-si (KR); LEE, Kyung Eun, Yongin-si (KR); CHO, Nam Yong, Yongin-si (KR)
(74) Representative: Marks & Clerk LLP

(57) **Abstract**

A mother substrate includes: a support substrate; a first organic layer on one surface of the support substrate; a first inorganic layer on the first organic layer and covering an edge of the first organic layer; a second organic layer on the first inorganic layer; a second inorganic layer on the second organic layer and covering an edge of the second organic layer; a plurality of display cells on the second inorganic layer; and an encapsulation cover layer on a first inorganic encapsulation area in which the first inorganic layer and the second inorganic layer are in contact with each other.

## Description

### BACKGROUND

### 1. Field

Aspects of some embodiments of the present disclosure relate to a mother substrate including a plurality of display devices and a method for fabricating a display device.

### 2. Description of the Related Art

As the information society develops, the demand for display devices for displaying images has increased in various forms. Display devices include, for example, flat panel displays, such as liquid crystal displays, field emitting displays, or light emitting display panels. A light emitting display device may include an organic light emitting display device including an organic light emitting diode element as a light emitting element, or an inorganic light emitting display device including an inorganic light emitting diode element such as a light emitting diode (LED) as a light emitting element.

In the organic light emitting display device, a portion of the inorganic film may be removed due to physical contact with manufacturing equipment and high-pressure injection of a cleaning solution of the cleaning equipment during a process of manufacturing. In this case, a seam may be generated in the encapsulation layer for encapsulating the organic light emitting diode element due to the transparent inorganic particles that are part of the removed inorganic layer. When moisture or oxygen permeates through the seam, the organic light emitting diode element may be oxidized and may not emit light.

The above information disclosed in this Background section is only for enhancement of understanding of the background and therefore the information discussed in this Background section does not necessarily constitute prior art.

### SUMMARY

Aspects and features of some embodiments of the present disclosure include a mother substrate including a plurality of display devices capable of reducing or preventing the occurrence of the seam in an encapsulation layer due to transparent inorganic particles that are part of the dropped inorganic layer.

Aspects and features of some embodiments of the present disclosure provide a method of manufacturing a display device capable of reducing or preventing the seam from being generated in an encapsulation layer due to transparent inorganic particles that are part of the dropped inorganic layer.

According to one or more embodiments of the present disclosure, there is provided a mother substrate including a support substrate, a first organic layer on one surface of the support substrate, a first inorganic layer on the first organic layer and covering an edge of the first organic layer, a second organic layer on the first inorganic layer, a second inorganic layer on the second organic layer and covering an edge of the second organic layer, a plurality of display cells on the second inorganic layer, and an encapsulation cover layer on a first inorganic encapsulation area in which the first inorganic layer and the second inorganic layer are in contact with each other.

According to some embodiments, the encapsulation cover layer may cover the entirety of the first inorganic encapsulation area.

According to some embodiments, a portion of the first inorganic encapsulation area may be exposed without being covered by the encapsulation cover layer.

According to some embodiments, a width of the encapsulation cover layer may be greater than a width of the first inorganic encapsulation area.

According to some embodiments, each of the plurality of display cells may include a plurality of thin film transistors on the second inorganic layer, at least one planarization layer on the plurality of thin film transistors, a plurality of light emitting elements on the at least one planarization layer, and an encapsulation layer encapsulating the plurality of light emitting elements. According to some embodiments, each of the plurality of thin film transistors includes an active layer and a gate electrode. According to some embodiments, each of the plurality of light emitting elements includes a first electrode, a light emitting layer, and a second electrode.

According to some embodiments, the encapsulation cover layer and the at least one planarization layer may include the same organic material.

According to some embodiments, each of the plurality of display cells may further include a bank covering an edge of the first electrode of each of the plurality of light emitting elements. According to some embodiments, the encapsulation cover layer and the bank may include the same organic material.

According to some embodiments, each of the plurality of display cells may further include a bank covering an edge of the first electrode of each of the plurality of light emitting elements, and a spacer on the bank. According to some embodiments, the encapsulation cover layer and the spacer may include the same organic material.

According to some embodiments, each of the plurality of display cells may further include a gate insulating layer between the active layer and the gate electrode, an interlayer insulating layer on the gate electrode, and a first connection electrode on the interlayer insulating layer and connected to the active layer through a contact hole penetrating the gate insulating layer and the interlayer insulating layer. According to some embodiments, the encapsulation cover layer and the first connection electrode may include the same metal material.

According to some embodiments, the encapsulation layer may include a first encapsulation inorganic layer on the second electrode of each of the light emitting elements, an encapsulation organic layer on the first encapsulation inorganic layer, a second encapsulation inorganic layer on the encapsulation organic layer, and a second inorganic encapsulation area in which the second inorganic layer, the first encapsulation inorganic layer, and the second encapsulation inorganic layer are sequentially stacked surrounds each of the plurality of display cells.

According to some embodiments, the encapsulation cover layer may include a metal material.

According to one or more embodiments of the present disclosure, a method for fabricating a display device includes: sequentially forming a first organic layer, a first inorganic layer, a second organic layer, and a second inorganic layer on a support substrate, forming a plurality of display cells and an encapsulation cover layer on the second inorganic layer, separating the support substrate from the first organic layer, cutting the plurality of display cells, forming the plurality of display cells and the encapsulation cover layer on the second inorganic layer, and forming the encapsulation cover layer on a first inorganic encapsulation area in which a first inorganic layer not covered by the second organic layer and the second inorganic layer contact each other.

According to some embodiments, the encapsulation cover layer may cover the entire first inorganic encapsulation area.

According to some embodiments, a portion of the first inorganic encapsulation area may be exposed without being covered by the encapsulation cover layer.

According to some embodiments, the separating the support substrate from the first organic layer may include inserting a cutting unit between the support substrate and the first organic layer in an insertion area where the first inorganic encapsulation area is exposed without being covered by the encapsulation cover layer, and cutting between the support substrate and the first organic layer along the first inorganic encapsulation area with the cutting unit.

According to some embodiments, a width of the encapsulation cover layer may be greater than a width of the first inorganic encapsulation area.

According to some embodiments, the encapsulation cover layer may be formed of an organic material.

According to some embodiments, the encapsulation cover layer may be formed of a metal material.

According to some embodiments, the method may further include forming the plurality of display cells and the encapsulation cover layer on the second inorganic layer, forming a plurality of thin film transistors on the second inorganic layer, simultaneously forming at least one planarization layer on the plurality of thin film transistors and the encapsulation cover layer of an organic material, forming a plurality of light emitting elements on the at least one planarization layer, and forming an encapsulation layer to encapsulate the plurality of light emitting elements.

According to some embodiments, the method may further include forming the plurality of display cells and the encapsulation cover layer on the second inorganic layer, forming a plurality of thin film transistors on the second inorganic layer, forming at least one planarization layer covering the plurality of thin film transistors, and forming a first electrode of each of a plurality of light emitting elements on the at least one planarization layer, simultaneously forming a bank covering an edge of a first electrode of each of the plurality of light emitting elements and the encapsulation cover layer of an organic material, forming a light emitting layer and a second electrode of each of the plurality of light emitting elements on the first electrode of each of the plurality of light emitting elements exposed without being covered by the bank, and forming an encapsulation layer for encapsulating the plurality of light emitting elements.

At least some of the above and other features of the invention are set out in the claims.

According to the aforementioned and other embodiments of the present disclosure, it may be possible to prevent or reduce damage to the first inorganic encapsulation area due to physical contact with the manufacturing equipment and high-pressure injection of the cleaning liquid of the cleaning equipment during the process of manufacturing due to the encapsulation cover layer. Therefore, it may be possible to prevent or reduce instances of a portion of the first inorganic layer and the second inorganic layer of the first inorganic encapsulation area falling off.

Accordingly, it may be possible to reduce or prevent the occurrence of the seam in the encapsulation layer due to the transparent inorganic particles that are part of the dropped inorganic layer.

### BRIEF DESCRIPTION OF THE DRAWINGS

The above and other embodiments and features of the present disclosure will become more apparent by describing aspects of some embodiments thereof with reference to the attached drawings, in which:
FIG. 1 is a perspective view illustrating a mother substrate including a plurality of display cells according to some embodiments.
FIG. 2 is a layout diagram illustrating a support substrate of a mother substrate, a plurality of display cells, a first inorganic encapsulation area, and a second inorganic encapsulation area according to some embodiments.
FIG. 3 is a cross-sectional view illustrating an example of a support substrate of a mother substrate, a first organic layer, a second organic layer, a first inorganic layer, a second inorganic layer, a first inorganic encapsulation area, and a display cell cut along the line A-A' of FIG. 2.
FIG. 4 is a cross-sectional view illustrating an area A of FIG. 3 in more detail.
FIG. 5 is a cross-sectional view illustrating seam generated when transparent inorganic particles of the first inorganic encapsulation area are located on an encapsulation layer of a display cell in FIG. 4.
FIG. 6 is a layout diagram illustrating a support substrate of a mother substrate, a plurality of display cells, a first inorganic encapsulation area, a second inorganic encapsulation area, and an encapsulation cover layer according to some embodiments.
FIG. 7 is a cross-sectional view illustrating an example of a support substrate of a mother substrate, a first organic layer, a second organic layer, a first inorganic layer, a second inorganic layer, a first inorganic encapsulation area, and an encapsulation cover layer cut along the line B-B' in FIG. 6.
FIG. 8 is a cross-sectional view illustrating another example of a support substrate of a mother substrate, a first organic layer, a second organic layer, a first inorganic layer, a second inorganic layer, a first inorganic encapsulation area, and an encapsulation cover layer cut along the line B-B' in FIG. 6.
FIG. 9 is a layout diagram illustrating a support substrate of a mother substrate, a plurality of display cells, a first inorganic encapsulation area, a second inorganic encapsulation area, and an encapsulation cover layer according to some embodiments.
FIG. 10 is a flowchart illustrating a manufacturing method of a display device according to some embodiments.
FIGS. 11 to 14 are cross-sectional views illustrating a manufacturing method of a display device according to some embodiments.
FIG. 15 is a flowchart illustrating a forming method of a plurality of display cells and an encapsulation cover layer according to some embodiments.
FIGS. 16a, 16b, 17a, 17b, 18a, and 18b are cross-sectional views illustrating a forming method of a plurality of display cells and an encapsulation cover layer according to some embodiments.
FIG. 19 is a flowchart illustrating a forming method of a plurality of display cells and an encapsulation cover layer according to some embodiments.
FIGS. 20a, 20b, 21a, 21b, 22a, and 22b are cross-sectional views illustrating a forming method of a plurality of display cells and an encapsulation cover layer according to some embodiments.
FIG. 23 is a flowchart illustrating a forming method of a plurality of display cells and an encapsulation cover layer according to some embodiments.
FIGS. 24a, 24b, 25a, 25b, 26a, and 26b are cross-sectional views illustrating a plurality of display cells and a forming method of an encapsulation cover layer according to some embodiments.
FIG. 27 is a flowchart illustrating a forming method of a plurality of display cells and an encapsulation cover layer according to some embodiments.
FIGS. 28a, 28b, 29a, 29b, 30a, and 30b are cross-sectional views illustrating a plurality of display cells and a forming method of an encapsulation cover layer according to some embodiments.

### DETAILED DESCRIPTION

Aspects and features of embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure might not be described.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

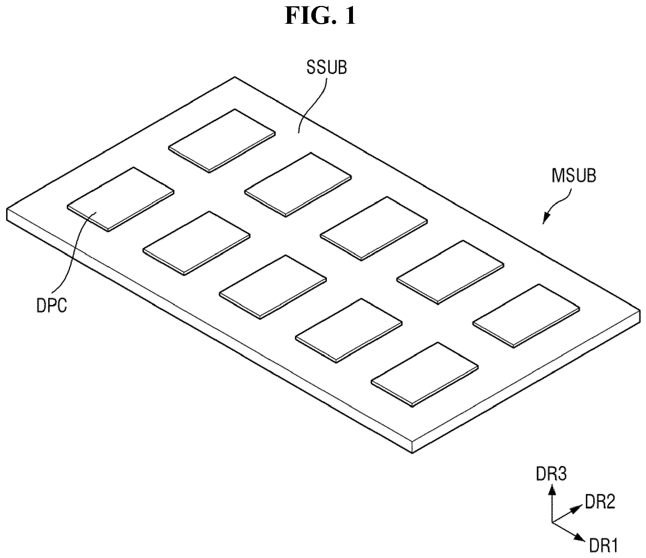

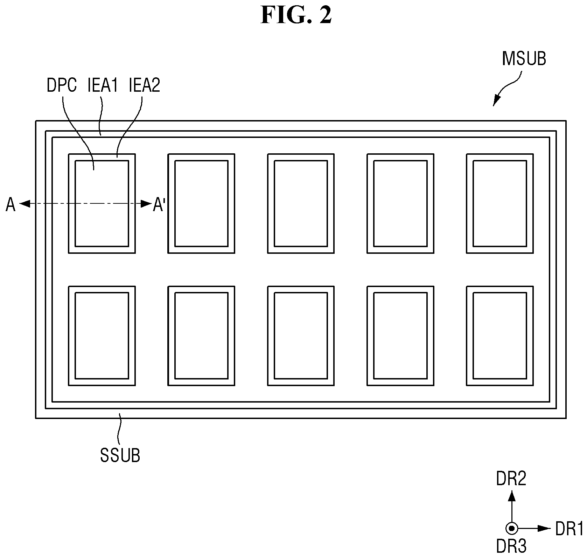

FIG. 1 is a perspective view illustrating a mother substrate including a plurality of display cells according to some embodiments. FIG. 2 is a layout diagram illustrating a support substrate of a mother substrate, a plurality of display cells, a first inorganic encapsulation area, and a second inorganic encapsulation area according to some embodiments.

Referring to FIGS. 1 and 2, a mother substrate MSUB according to one or more embodiments includes a support substrate SSUB, a plurality of display cells DPC, a first inorganic encapsulation area IEA1, and a second inorganic encapsulation area IEA2.

The support substrate SSUB may be a substrate having rigidity to support the plurality of display cells DPC while manufacturing the plurality of display cells DPC. For example, the support substrate SSUB may be a glass substrate or a plastic substrate such as polyethylene terephthalate (PET).

The support substrate SSUB may have a hexahedral shape including a first surface corresponding to a front surface, a second surface corresponding to a rear surface, and a plurality of side surfaces. In this case, the first surface and the second surface may have a rectangular shape having a long side in the first direction DR1 and a short side in the second direction DR2. The first surface and the second surface may be opposite to each other. In addition, among the plurality of side surfaces, an upper surface and a lower surface have a rectangular shape having a long side in the first direction DR1 and a short side in the third direction DR3, and the left side and the right side may have a rectangular shape having a long side in the second direction DR2 and a short side in the third direction DR3. However, the shape of the support substrate SSUB is not limited to a hexahedron, and may have a shape other than a hexahedron.

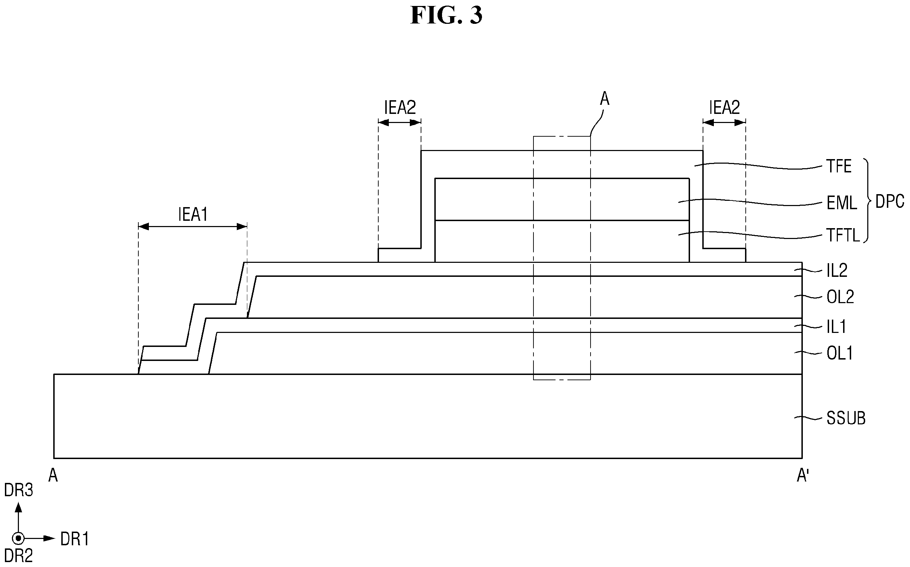

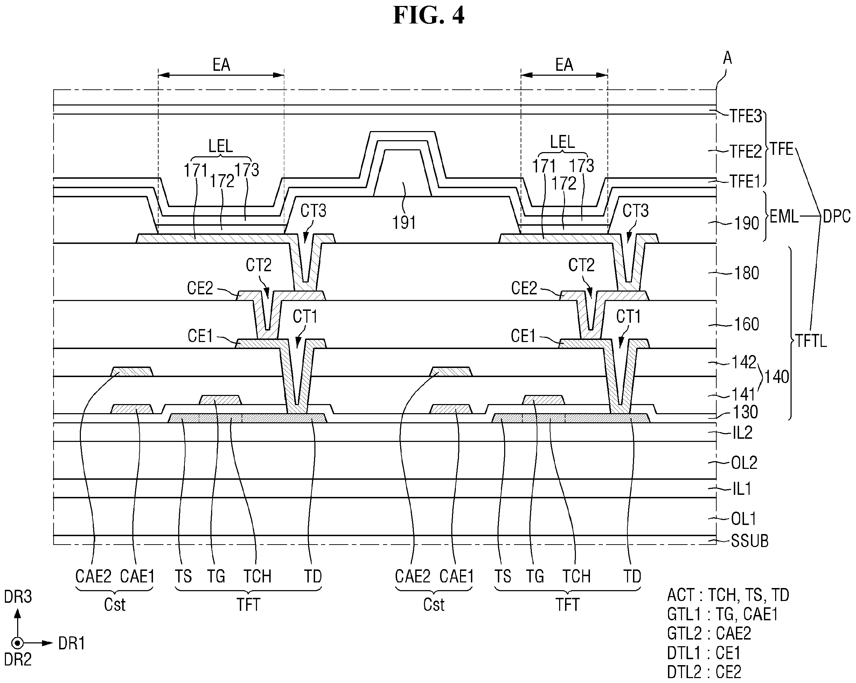

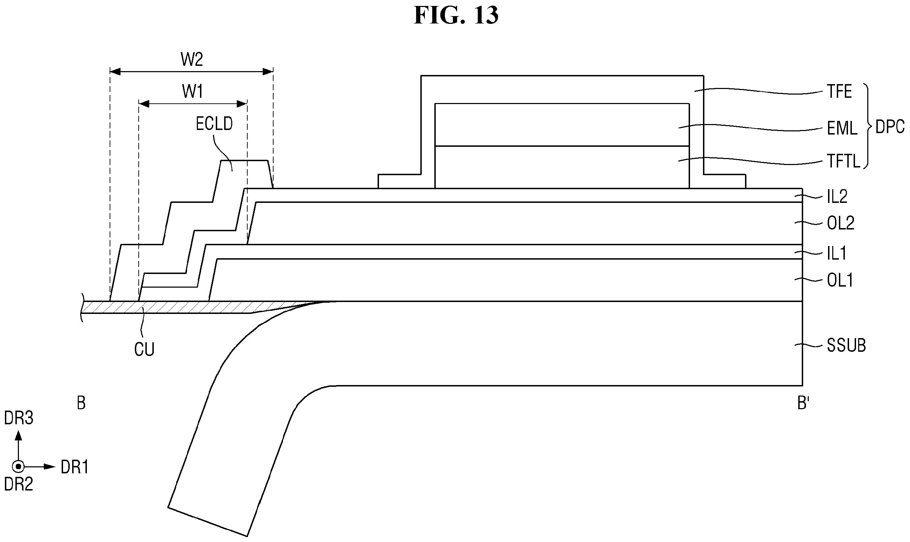

The plurality of display cells DPC may be simultaneously or concurrently formed on the support substrate SSUB and then cut by a laser or a cutting unit in a cutting process. Accordingly, a plurality of display devices (or display panels) may be manufactured. The plurality of display cells DPC may be arranged in the first direction DR1 and the second direction DR2. The plurality of display cells DPC may be arranged in M (M is a positive integer) number of rows and N (N is a positive integer) number of columns. FIGS. 1 and 2 illustrate that the plurality of display cells DPC are arranged in two rows and five columns, the embodiments of the present disclosure are not limited thereto. A detailed description of each of the plurality of display cells DPC will be described later with reference to FIGS. 3 and 4. Also, a detailed description of a manufacturing method of the display device (or display panel) will be described later with reference to FIG. 13.

A first inorganic encapsulation area IEA1 may be arranged along an edge of the support substrate SSUB. The first inorganic encapsulation area IEA1 may be arranged to surround the plurality of display cells DPC. A second inorganic encapsulation area IEA2 may be arranged to surround each of the plurality of display cells DPC. Each of the plurality of display cells DPC may be protected from moisture permeation by the first inorganic encapsulation area IEA1 and the second inorganic encapsulation area IEA2.

FIG. 3 is a cross-sectional view illustrating an example of a support substrate of a mother substrate, a first organic layer, a second organic layer, a first inorganic layer, a second inorganic layer, a first inorganic encapsulation area, and a display cell cut along A-A' of FIG. 2.

Referring to FIG. 3, the mother substrate MSUB further includes a first organic layer OL1, a first inorganic layer IL1, a second organic layer OL2, and a second inorganic layer IL2 according to some embodiments.

The first organic layer OL1 may be located on the first surface of the support substrate SSUB. The edge of the first surface of the support substrate SSUB may be exposed without being covered by the first organic layer OL1. The plurality of side surfaces of the support substrate SSUB may also not be covered by the first organic layer OL1.

The first inorganic layer IL1 may be located on the first organic layer OL1. The first inorganic layer IL1 may cover the entire first organic layer OL1. That is, the first inorganic layer IL1 may cover the top surface and side surfaces of the first organic layer OL1. The first inorganic layer IL1 may be located on a portion of an edge of the first surface of the support substrate SSUB that is not covered by the first organic layer OL1 and is exposed. That is, another portion of the edge of the first surface of the support substrate SSUB may be exposed without being covered by the first inorganic layer IL1.

The second organic layer OL2 may be located on the first inorganic layer IL1. An edge of the first inorganic layer IL1 may be exposed without being covered by the second organic layer OL2.

The second inorganic layer IL2 may be located on the second organic layer OL2. The second inorganic layer IL2 may cover the entire second organic layer OL2. That is, the second inorganic layer IL2 may cover the top surface and side surfaces of the second organic layer OL2.

The second inorganic layer IL2 may be located on the exposed first inorganic layer IL1 without being covered by the second organic layer OL2. The second inorganic layer IL2 may be in contact with the exposed first inorganic layer IL1 without being covered by the second organic layer OL2. An area in which the first inorganic layer IL1 and the second inorganic layer IL2 contact each other may be defined as the first inorganic encapsulation area IEA1.

When the first organic layer OL1 and the second organic layer OL2 are exposed to the outside, the active layer of each of the thin film transistors of the display cells DPC may be carbonized by a laser generated in a laser process for crystallizing amorphous silicon (a-Si) into polycrystalline silicon (poly-Si). It may be possible to prevent or reduce instances of the first organic layer OL1 and the second organic layer OL2 being exposed to the outside due to the first inorganic encapsulation area IEA1, so that carbonization of the first organic layer OL1 and the second organic layer OL2 may be prevented. Therefore, it may be possible to prevent or reduce the occurrence of product defects due to the particles due to carbonization of the first organic layer OL1 and the second organic layer OL2.

Each of the first organic layer OL1 and the second organic layer OL2 may be formed of an organic material such as an acryl resin, an epoxy resin, a phenolic resin, a polyamide resin, and a polyimide resin. The first organic layer OL1 and the second organic layer OL2 may be formed of the same organic material or different organic material.

Each of the first inorganic layer OL1 and the second inorganic layer OL2 may be formed of an inorganic material such as a silicon nitride layer, a silicon oxynitride layer, a silicon oxide layer, a titanium oxide layer, and an aluminium oxide layer. Alternatively, each of the first inorganic layer IL1 and the second inorganic layer IL2 may be formed as a multilayer in which a plurality of layers of a silicon nitride layer, a silicon oxynitride layer, a silicon oxide layer, a titanium oxide layer, and an aluminium oxide layer are alternately stacked. The first inorganic layer IL1 and the second inorganic layer IL2 may be formed of the same inorganic material or different inorganic materials.

Each of the plurality of display cells DPC may include a thin film transistor layer TFTL, a light emitting element layer EML, and an encapsulation layer TFE.

The thin film transistor layer TFTL may include a plurality of thin film transistors. The thin film transistor layer TFTL may be located on the second inorganic layer IL2.

The light emitting element layer EML may include a plurality of light emitting elements. The plurality of light emitting elements may receive a driving current or a driving voltage from the thin film transistors to emit light with a luminance (e.g., a set or predetermined luminance). The light emitting element layer EML may be located on the thin film transistor layer TFTL.

The encapsulation layer TFE may be arranged to surround the thin film transistor layer TFTL and the light emitting element layer EML. The encapsulation layer TFE may include at least one inorganic film and at least one organic film. At least one inorganic layer may be located on a side surface of the thin film transistor layer TFTL and an upper surface and a side surface of the light emitting element layer EML. At least one organic layer may be located on the upper surface of the light emitting element layer EML. Therefore, the thickness of the encapsulation layer TFE located on the side surface of the thin film transistor layer TFTL and the side surface of the light emitting element layer EML may be smaller than the thickness of is the thickness of the encapsulation layer TFE located on the upper surface of the light emitting element layer EML.

An area in which at least one inorganic layer of the encapsulation layer TFE and the second inorganic layer IL2 contact each other may be defined as the second inorganic encapsulation area IEA2. Because the second inorganic encapsulation area IEA2 is arranged to surround each of the plurality of display cells DPC, each of the plurality of display cells DPC may be protected from moisture permeation by the second inorganic encapsulation area IEA2.

A detailed description of the thin film transistor layer TFTL, the light emitting element layer EML, and the encapsulation layer TFE will be described later with reference to FIG. 4.

FIG. 4 is a cross-sectional view illustrating an area A of FIG. 3 in detail.

Referring to FIG. 4, each of the plurality of display cells DPC may include a thin film transistor layer TFTL, a light emitting element layer EML, and an encapsulation layer TFE.

The thin film transistor layer TFTL includes an active layer ACT, a first gate layer GTL1, a second gate layer GTL2, a first data metal layer DTL1, and a second data metal layer DTL2. In addition, the thin film transistor layer TFTL includes a gate insulating layer 130, an interlayer insulating layer 140, a first planarization layer 160, and a second planarization layer 180. The thin film transistor layer TFTL includes a plurality of thin film transistors TFT, and each of the plurality of thin film transistors TFT includes a channel TCH, a gate electrode TG, a first electrode TS, and a second electrode TD. The interlayer insulating layer 140 includes a first interlayer insulating layer 141, a second interlayer insulating layer 142.

The active layer ACT may be located on the second inorganic layer IL2. The active layer ACT may include a silicon semiconductor such as polycrystalline silicon, single crystal silicon, and low-temperature polycrystalline silicon, or an oxide sem iconductor.

The active layer ACT may include the channel TCH, a first electrode TS, and the second electrode TD of each of the plurality of thin film transistors TFT. The channel TCH may be an area overlapping the gate electrode TG of the thin film transistor TFT in the third direction DR3 which is the thickness direction of the substrate SUB. The first electrode TS may be located on one side of the channel TCH, and the second electrode TD may be located on the other side of the channel TCH. The first electrode TS and the second electrode TD may be areas that do not overlap the gate electrode TG in the third direction DR3. The first electrode TS and the second electrode TD may be areas in which ions are doped into a silicon semiconductor or an oxide semiconductor to have conductivity.

The gate insulating layer 130 may be located on the active layer ACT. The gate insulating layer 130 may be formed of an inorganic layer, for example, a silicon nitride layer, a silicon oxynitride layer, a silicon oxide layer, a titanium oxide layer, or an aluminium oxide layer.

The first gate layer GTL1 may be located on the gate insulating layer 130. The first gate layer GTL1 may include a gate electrode TG of each of the plurality of thin film transistors TFT and a first capacitor electrode CAE1. The first gate layer GTL1 may be formed as a single layer or multiple layers made of any one of molybdenum (Mo), aluminium (Al), chromium (Cr), gold (Au), titanium (Ti), nickel (Ni), neodymium (Nd), and copper (Cu) or an alloy thereof.

A first interlayer insulating layer 141 may be located on the first gate layer GTL1. The first interlayer insulating layer 141 may be formed of the inorganic layer, for example, the silicon nitride layer, the silicon oxynitride layer, the silicon oxide layer, the titanium oxide layer, or the aluminium oxide layer.

The second gate layer GTL2 may be located on the first interlayer insulating layer 141. The second gate layer GTL2 may include a second capacitor electrode CAE2. The second capacitor electrode CAE2 may overlap the first capacitor electrode CAE1 in the third direction DR3. The capacitor Cst may include the first capacitor electrode CAE1 and the second capacitor electrode CAE2. The second gate layer GTL2 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The second interlayer insulating layer 142 may be located on the second gate layer GTL2. The second interlayer insulating layer 142 may be formed of an inorganic layer, for example, the silicon nitride layer, the silicon oxynitride layer, the silicon oxide layer, the titanium oxide layer, or the aluminium oxide layer.

The first data metal layer DTL1 including a first connection electrode CE1 may be located on the second interlayer insulating layer 142. The first connection electrode CE1 may be connected to the first electrode TS or the second electrode TD of the thin film transistor TFT through a first contact hole CT1 penetrating the gate insulating layer 130, the first interlayer insulating layer 141, and the second interlayer insulating layer 142. The first data metal layer DTL1 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

A first planarization layer 160 may be located on the first data metal layer DTL1 for flattening a step caused by the active layer ACT, the first gate layer GTL1, the second gate layer GTL2, and the first data metal layer DTL1. The first planarization layer 160 is formed of an organic film such as acrylic resin, epoxy resin, phenolic resin, polyamide resin, polyimide resin, etc.

The second data metal layer DTL2 may be located on the first planarization layer 160. The second data metal layer DTL2 may include a second connection electrode CE2. The second connection electrode CE2 may be connected to the first connection electrode CE1 through a second contact hole CT2 penetrating the first planarization layer 160. The second data metal layer DTL2 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The second planarization layer 180 may be located on the second data metal layer DTL2. The second planarization film 180 is formed of an organic film such as acrylic resin, epoxy resin, phenolic resin, polyamide resin, polyimide resin, etc.

The light emitting element layer EML may be located on the second planarization layer 180. The light emitting element layer EML may include a plurality of light emitting elements LEL and a bank 190. Each of the plurality of light emitting elements LEL may be an organic light emitting diode element including a pixel electrode 171, a light emitting layer 172, and a common electrode 173, but embodiments of the present disclosure are not limited thereto.

The pixel electrode 171 may be located on the second planarization layer 180. The pixel electrode 171 may be connected to the second connection electrode CE2 through a third contact hole CT3 penetrating the second planarization layer 180.

In a top emitting structure that emits light in the direction of the common electrode 173 based on the light emitting layer 172, the pixel electrode 171 may be formed of a metal material having a high reflectance such as a layered structure of aluminium and titanium (Ti/Al/Ti), a layered structure of aluminium and ITO (Indium Tin Oxide) (ITO/AI/ITO), APC alloy, and a layered structure of APC alloy and ITO (ITO/APC/ITO). The APC alloy is an alloy of silver (Ag), palladium (Pd), and copper (Cu).

The bank 190 may be arranged to cover the edges of each of the pixel electrodes 171 on the second planarization layer 180 to define the plurality of light emitting units EA. The bank 190 may be formed of an organic layer such as an acrylic resin, an epoxy resin, a phenolic resin, a polyamide resin, or a polyimide resin.

Each of the plurality of light emitting units EA represents an area that the pixel electrode 171, the light emitting layer 172, and the common electrode 173 are sequentially stacked so that holes from the pixel electrode 171 and electrons from the common electrode 173 recombine in the light emitting layer 172.

The light emitting layer 172 may be located on the pixel electrode 171. The light emitting layer 172 may include an organic material to emit a color (e.g., a set or predetermined color). For example, the light emitting layer 172 includes a hole transporting layer, an organic material layer, and an electron transporting layer.

The common electrode 173 may be located on the light emitting layer 172. The common electrode 173 may be arranged to cover the light emitting layer 172. The common electrode 173 may be a common layer commonly formed in the plurality of light emitting units EA. A capping layer may be formed on the common electrode 173.

In the upper light emitting structure, the common electrode 173 may be formed of a Transparent Conductive Oxide (TCO) such as ITO or IZO that may transmit light, or a semi-transmissive conductive material such as magnesium (Mg), silver (Ag), or an alloy of magnesium (Mg) and silver. When the common electrode 173 is formed of a semi-transmissive conductive material, light output efficiency may be increased by the micro cavity.

A spacer 191 may be located on the bank 190. The spacer 191 may serve to support the mask during the process of manufacturing the light emitting layer 172. The spacer 191 may be formed of an organic layer such as an acrylic resin, an epoxy resin, a phenolic resin, a polyamide resin, or a polyimide resin.

The encapsulation layer TFE may be located on the common electrode 173. The encapsulation layer TFE includes at least one inorganic film to prevent oxygen or moisture from penetrating into the light emitting element layer EML. In addition, the encapsulation layer TFE includes at least one organic film to protect the light emitting element layer EML from foreign material such as dust. For example, the encapsulation layer TFE may include a first encapsulation inorganic layer TFE1, an encapsulation organic layer TFE2, and a second encapsulation inorganic layer TFE3.

The first encapsulation inorganic layer TFE1 may be located on the common electrode 173, an encapsulation organic layer TFE2 may be located on the first encapsulation inorganic layer TFE1, and the second encapsulation inorganic layer TFE3 may be located on the encapsulation organic layer TFE2. The first encapsulation inorganic layer TFE1 and the second encapsulation inorganic layer TFE3 may be formed as a multilayer in which one or more inorganic layers of silicon nitride layer, silicon oxynitride layer, silicon oxide layer, titanium oxide layer, and aluminium oxide layer are alternately stacked. The encapsulation organic layer TFE2 may be an organic film such as an acrylic resin, an epoxy resin, a phenolic resin, a polyamide resin, or a polyimide resin.

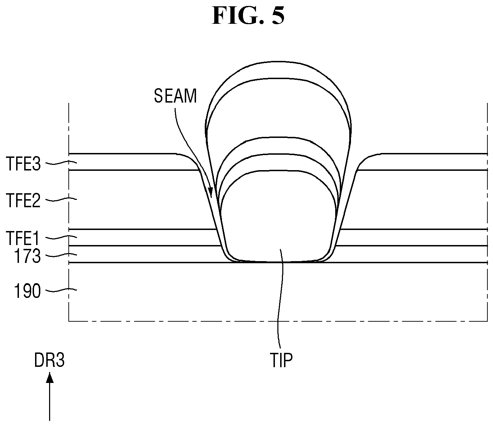

FIG. 5 is a cross-sectional view illustrating the seam generated when transparent inorganic particles of the first inorganic encapsulation area is located on an encapsulation layer of a display cell in FIG. 4.

Referring to FIG. 5, in order to prevent the first organic layer OL1 and the second organic layer OL2 from being carbonized by the laser in a laser process for crystallizing the active layer of each of the thin film transistors of the display cells (DPC) from amorphous silicon (a-Si) to polycrystalline silicon (poly-Si) during the manufacturing process of the display device, the first inorganic encapsulation area IEA1 in which the first inorganic layer IL1 and the second inorganic layer IL2 contact each other is formed. However, the adhesion between the first inorganic layer IL1 and the second inorganic layer IL2 of the first inorganic encapsulation area IEA1 is not high. Accordingly, when the mother substrate MSUB physically contacts with a pin or mask of equipment during the manufacturing process of the display device, or when damage is received by high-pressure spraying of the cleaning liquid during wet cleaning, the transparent inorganic particle TIP may come off from the first inorganic encapsulation area IEA1.

When the transparent inorganic particles TIP are located on the bank 190 as shown in FIG. 5, the common electrode 173, the first encapsulation inorganic layer TFE1, the encapsulation organic layer TFE2, and the second encapsulation inorganic layer TFE3 may be cut off due to the step difference of transparent inorganic particle TIP. That is, the seam SEAM may be formed in the encapsulation layer TFE, and moisture or oxygen may permeate through the seam SEAM, so that the seam SEAM may become a moisture permeation path. Accordingly, the light emitting elements LEL may be oxidized by moisture or oxygen penetrating through the seam SEAM, and in this case, the light emitting elements LEL may not emit light. Therefore, it is necessary to prevent the transparent inorganic particles TIP from being located on the bank 190 because a part of the first inorganic encapsulation area IEA1 is dropped off.

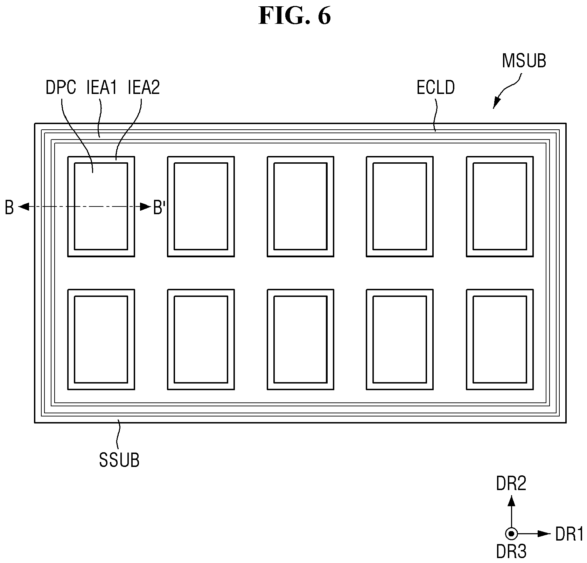

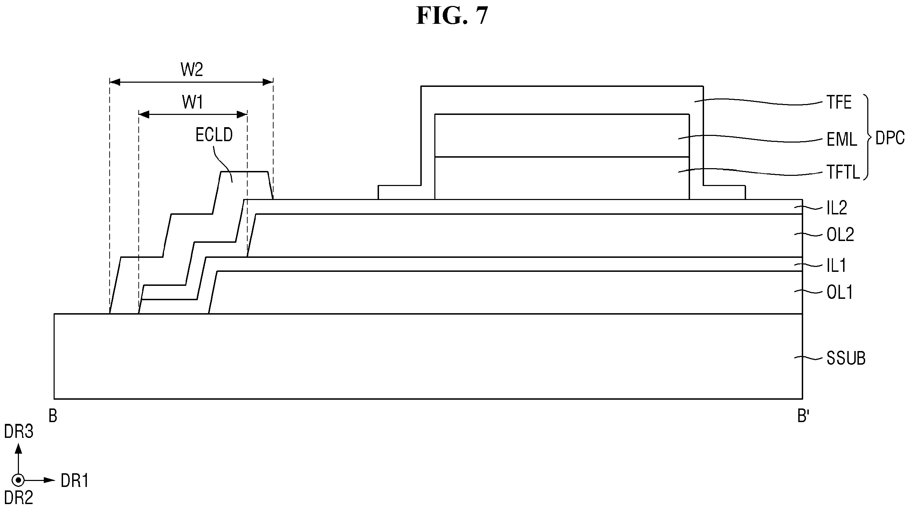

FIG. 6 is a layout diagram illustrating a support substrate of a mother substrate, a plurality of display cells, a first inorganic encapsulation area, a second inorganic encapsulation area, and an encapsulation cover layer according to one or more embodiments. FIG. 7 is a cross-sectional view illustrating an example of a support substrate of a mother substrate, a first organic layer, a second organic layer, a first inorganic layer, a second inorganic layer, a first inorganic encapsulation area, and an encapsulation cover layer cut along B-B' in FIG. 6.

The embodiments of FIGS. 6 and 7 are different from the embodiments of FIGS. 2 and 3 in that the mother substrate MSUB further includes an encapsulation cover layer ECLD. In FIGS. 6 and 7, descriptions overlapping those of the embodiments of FIGS. 2 and 3 will be omitted.

Referring to FIGS. 6 and 7, the encapsulation cover layer ECLD may overlap the first inorganic encapsulation area IEA1 in the third direction DR3. The encapsulation cover layer ECLD may cover the first inorganic encapsulation area IEA1. A width W2 of the encapsulation cover layer ECLD may be greater than a width W1 of the first inorganic encapsulation area IEA1. The encapsulation cover layer ECLD may be arranged along an edge of the support substrate SSUB. The encapsulation cover layer ECLD may be arranged to surround the plurality of display cells DPC.

The encapsulation cover layer ECLD may be located on the second inorganic layer IL2. The encapsulation cover layer ECLD may be located on a side surface of the first inorganic layer IL1 and an upper surface and a side surface of the second inorganic layer IL2. The support substrate SSUB exposed without being covered by the first inorganic layer IL1 or the encapsulation cover layer ECLD may be located on the first surface.

The encapsulation cover layer ECLD may be formed of an organic material such as acrylic resin, epoxy resin, phenolic resin, polyamide resin, polyimide resin, etc. In this case, the encapsulation cover layer ECLD may be formed of the same organic material as any one of the first planarization layer 160, the second planarization layer 180, the bank 190, and the spacer 191. Also, a thickness of the encapsulation cover layer ECLD may be greater than a thickness of the first inorganic layer IL1 and a thickness of the second inorganic layer IL2.

In summary, the adhesive force between the first inorganic layer IL1 and the second inorganic layer IL2 of the first inorganic encapsulation area IEA1 is not high. Accordingly, when the encapsulation cover layer ECLD completely covers the first inorganic encapsulation area IEA1, it may be possible to prevent or reduce instances of the first inorganic encapsulation area IEA1 being damaged by physical contact with manufacturing equipment during the manufacturing process and the high-pressure injection of the cleaning liquid of the cleaning equipment. Therefore, it may be possible to prevent or reduce instances of a portion of the first inorganic layer IL1 and the second inorganic layer IL2 of the first inorganic encapsulation area IEA1 falling off.

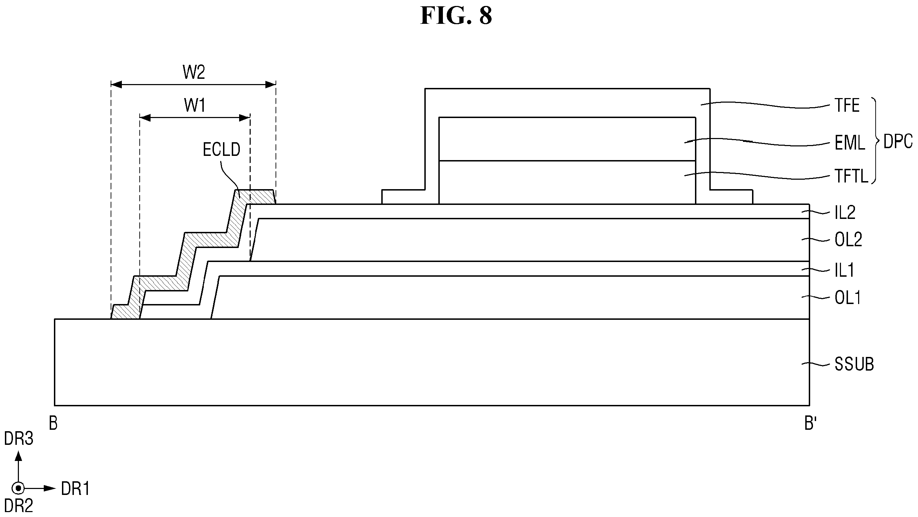

FIG. 8 is a cross-sectional view illustrating another example of a support substrate of a mother substrate, a first organic layer, a second organic layer, a first inorganic layer, a second inorganic layer, a first inorganic encapsulation area, and an encapsulation cover layer cut along B-B' in FIG. 6.

The embodiments of FIG. 8 are different from the embodiments of FIG. 7 in that the encapsulation cover layer ECLD is formed of a metal material instead of an organic material. In FIG. 8, some repeated description overlapped with the embodiments of FIG. 7 may be omitted.

Referring to FIG. 8, the encapsulation cover layer ECLD may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof. Alternatively, the encapsulation cover layer ECLD may be formed of a stacked structure of aluminium and titanium (Ti/Al/Ti), a stacked structure of aluminium and indium tin oxide (ITO/AI/ITO), an APC alloy, an APC alloy, and a stacked structure of ITO (ITO/APC/ITO). In this case, the encapsulation cover layer ECLD may be formed of the same metal material as any one of the first gate metal layer GTL1, the second gate metal layer GTL2, the first data metal layer DTL1, the second data metal layer DTL2, and the pixel electrode 171. Also, a thickness of the encapsulation cover layer ECLD may be smaller than a thickness of the first organic layer OL1 and a thickness of the second organic layer OL2.

In summary, the encapsulation cover layer ECLD may be arranged to completely cover the first inorganic encapsulation area IEA1. In this case, it may be possible to prevent or reduce damage to the first inorganic encapsulation area IEA1 due to physical contact with manufacturing equipment and the high-pressure injection of the cleaning liquid of the cleaning equipment during the manufacturing process. Therefore, it may be possible to prevent or reduce instances of a portion of the first inorganic encapsulation area IEA1 falling off.

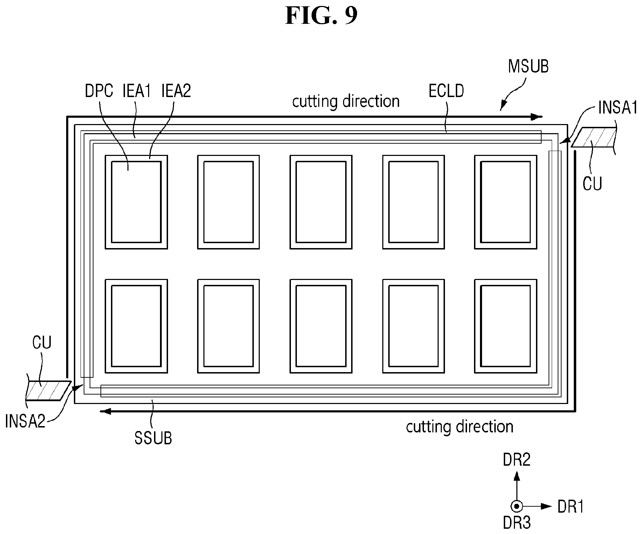

FIG. 9 is a layout diagram illustrating a support substrate of a mother substrate, a plurality of display cells, a first inorganic encapsulation area, a second inorganic encapsulation area, and an encapsulation cover layer according to one or more embodiments.

The embodiments of FIG. 9 are different from the embodiments of FIG. 6 in that a part of the encapsulation cover layer ECLD is removed. In FIG. 9, some repetitive description overlapping with the embodiments of FIG. 6 may be omitted.

Referring to FIG. 9, at least a portion of the first inorganic encapsulation area IEA1 may be exposed without being covered by the encapsulation cover layer ECLD. For example, when the first inorganic encapsulation area IEA1 has a planar shape of a rectangular frame, at least one of the four edges (or corners) of the first inorganic encapsulation area IEA1 may be exposed without being covered by the encapsulation cover layer ECLD.

When the encapsulation cover layer ECLD formed of the organic layer overlaps the first inorganic encapsulation area IEA1 in the process of separating the support substrate SSUB from the first organic layer OL1 using the cutting unit CU during the manufacturing process of the display device, it may be difficult to insert the cutting unit CU due to the encapsulation cover layer ECLD. Because the cutting unit CU needs to cut the first organic layer OL1 after cutting the encapsulation cover layer ECLD, the encapsulation cover layer ECLD may act as a kind of resistance. Therefore, wrinkles may occur in the first organic layer OL1 after cutting is completed due to the encapsulation cover layer ECLD. Accordingly, the removal area of the encapsulation cover layer ECLD is an area that facilitates insertion of the cutting unit CU, and may be the insertion area INSA1 and INSA2 into which the cutting unit CU is inserted.

The cutting unit CU inserted into a first insertion area INSA1 may cut the first organic layer OL1 adjacent to the support substrate SSUB along the first inorganic encapsulation area IEA1. In this case, the cutting unit CU inserted into the first insertion area INSA1 may cut the first organic layer OL1 from a lower right corner to a lower left corner of the first inorganic encapsulation area IEA1 in the first direction DR1 after the cutting unit CU cuts the first organic layer OL1 from the upper right corner to the lower right corner of the first inorganic encapsulation area IEA1 in the second direction DR2.

Then, the cutting unit CU inserted into the second insertion area INSA2 may cut the first organic layer OL1 adjacent to the support substrate SSUB along the first inorganic encapsulation area IEA1. In this case, the cutting unit CU inserted into the second insertion area INSA2 may cut the first organic layer OL1 from the upper left corner to the upper right corner of the first inorganic encapsulation area IEA1 in the first direction DR1 after the cutting unit CU cuts the first organic layer OL1 from the lower left corner to the upper left corner of the first inorganic encapsulation area IEA1 in the second direction DR2.

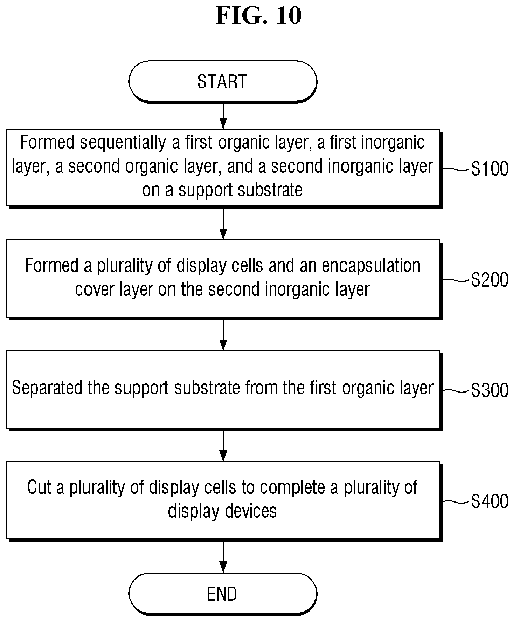

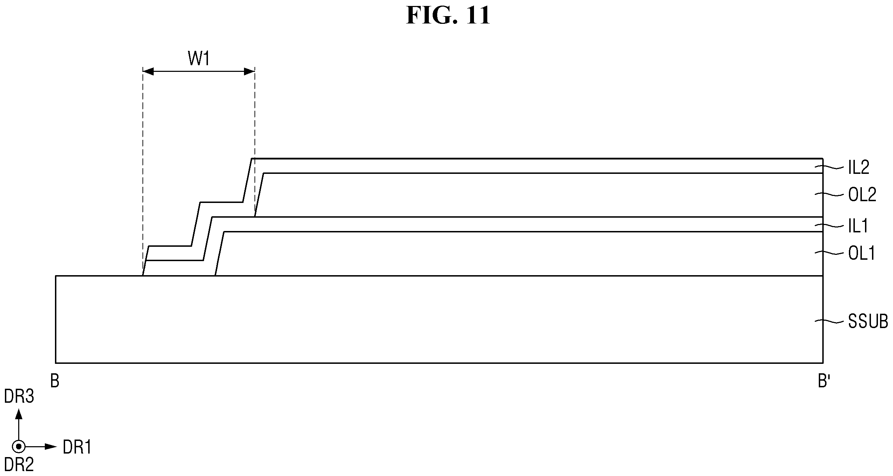

FIG. 10 is a flowchart illustrating a manufacturing method of a display device according to one or more embodiments. FIGS. 11 to 14 are cross-sectional views illustrating a manufacturing method of a display device according to one or more embodiments. Hereinafter, a method of manufacturing a display device according to some embodiments will be described in more detail with reference to FIGS. 10 to 14.

First, as shown in FIG. 11, the first organic layer OL1, the first inorganic layer IL1, the second organic layer OL2, and the second inorganic layer IL2 may be sequentially formed on the support substrate SSUB. (S100 in FIG. 10)

The first organic layer OL1 may be formed on the first surface of the support substrate SSUB. The edge of the first surface of the support substrate SSUB may be exposed without being covered by the first organic layer OL1.

Then, the first inorganic layer IL1 may be formed on the first organic layer OL1. The first inorganic layer IL1 may cover the top surface and side surfaces of the first organic layer OL1. The first inorganic layer IL1 may be located on a portion of an edge of the first surface of the supporting substrate SSUB not covered by the first organic layer OL1.

Then, the second organic layer OL2 may be formed on the first inorganic layer IL1. An edge of the first inorganic layer IL1 may be exposed without being covered by the second organic layer OL2.

Then, the second inorganic layer IL2 may be formed on the second organic layer OL2. The second inorganic layer IL2 may cover the top surface and side surfaces of the second organic layer OL2. The second inorganic layer IL2 may be located on the exposed first inorganic layer IL1 without being covered by the second organic layer OL2. Accordingly, the first inorganic encapsulation area IEA1, which is an area where the first inorganic layer IL1 and the second inorganic layer IL2 contact each other, may be formed.

When the first organic layer OL1 and the second organic layer OL2 are exposed to the outside, the active layer of each of the thin film transistors of the display cells DPC may be carbonized by a laser generated in a laser process for crystallizing amorphous silicon (a-Si) into polycrystalline silicon (poly-Si). It may be possible to prevent or reduce instances of the first organic layer OL1 and the second organic layer OL2 being exposed to the outside due to the first inorganic encapsulation area IEA1, so that carbonization of the first organic layer OL1 and the second organic layer OL2 may be prevented. Therefore, it may be possible to prevent or reduce the occurrence of product defects due to the particles due to carbonization of the first organic layer OL1 and the second organic layer OL2.

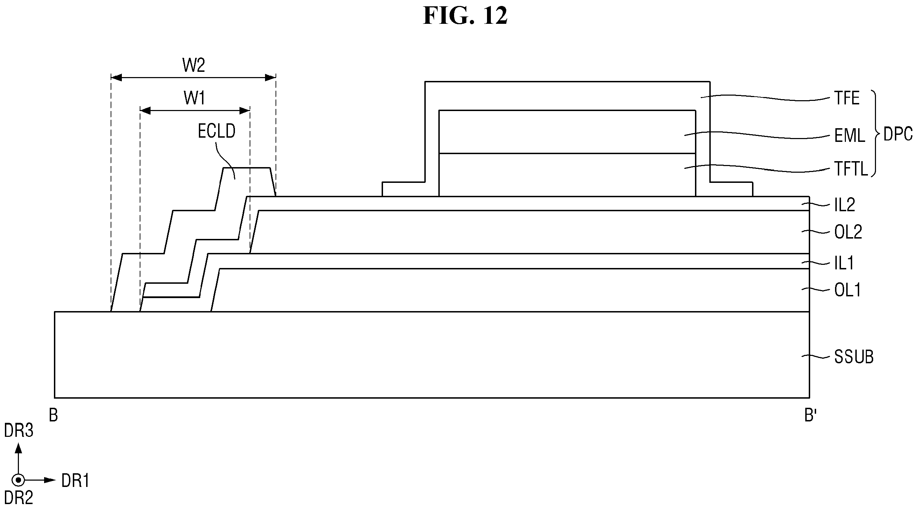

Second, as shown in FIG. 12, the plurality of display cells DPC and the encapsulation cover layer ECLD are formed on the second inorganic layer IL2. (S200 in FIG. 10)

The thin film transistor layer TFTL, the light emitting element layer EML, and the encapsulation layer TFE of each of the plurality of display cells DPC may be sequentially formed on the second inorganic layer IL2. That is, after the thin film transistor layer TFTL is formed on the second inorganic layer IL2, the light emitting element layer EML may be formed on the thin film transistor layer TFTL. Then, the encapsulation layer TFE may be formed on the side surface of the thin film transistor layer TFTL and the upper surface and side surface of the light emitting element layer EML. In this case, an area in which the first encapsulation inorganic layer TFE1 and the second encapsulation inorganic layer TFE3 of the encapsulation layer TFE contact the second inorganic layer IL2 may be defined as the second inorganic encapsulation area IEA2. Because the second inorganic encapsulation area IEA2 is arranged to surround each of the plurality of display cells DPC, each of the plurality of display cells DPC may be protected from moisture permeation by the second inorganic encapsulation area IEA2.

The encapsulation cover layer ECLD may be formed on the first inorganic encapsulation area IEA1. The adhesion between the first inorganic layer IL1 and the second inorganic layer IL2 of the first inorganic encapsulation area IEA1 is not high. Accordingly, when the encapsulation capping layer ECLD completely covers the first inorganic encapsulation area IEA1, it may be possible to prevent or reduce damage to the first inorganic encapsulation area IEA1 due to physical contact with manufacturing equipment and the high-pressure injection of the cleaning liquid of the cleaning equipment during the manufacturing process. Therefore, it may be possible to prevent or reduce instances of a portion of the first inorganic encapsulation area IEA1 falling off.

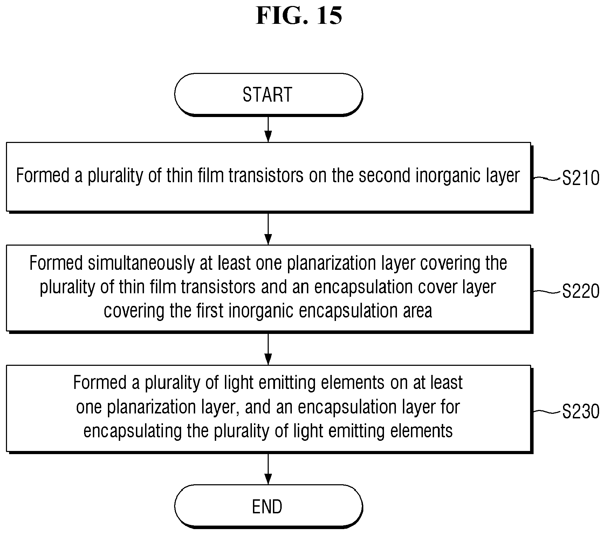

A detailed description of the plurality of display cells DPC and the encapsulation cover layer ECLD formed on the second inorganic layer IL2 will be described later with reference to FIGS. 15, 19, 23, and 27.

Third, as shown in FIG. 13, the support substrate SSUB is separated from the first organic layer OL1. (S300 in FIG. 10)

The support substrate SSUB may be separated from the first organic layer OL1 by using the cutting unit CU. In this case, the cutting unit CU may cut the first organic layer OL1 adjacent to the support substrate SSUB.

Meanwhile, it may be difficult to insert the cutting unit CU into the first organic layer OL1 due to the encapsulation cover layer ECLD. That is, because the cutting unit CU may cut the first organic layer OL1 after cutting the encapsulation cover layer ECLD, the encapsulation cover layer ECLD may act as a kind of resistance. Therefore, wrinkles may occur in the first organic layer OL1 after cutting is completed due to the encapsulation cover layer ECLD. Accordingly, in order to prevent wrinkles from being generated in the first organic layer OL1, insertion areas INSA1 and INSA2 in which at least a portion of the first inorganic encapsulation area IEA1 are exposed without being covered by the encapsulation cover layer ECLD may be formed as shown in FIG. 9.

The cutting unit CU inserted into the first insertion area INSA1 may cut the first organic layer OL1 adjacent to the support substrate SSUB along the first inorganic encapsulation area IEA1. In this case, the cutting unit CU inserted into the first insertion area INSA1 may cut the first organic layer OL1 from a lower right corner to a lower left corner of the first inorganic encapsulation area IEA1 in the first direction DR1 after the cutting unit CU cuts the first organic layer OL1 from the upper right corner to the lower right corner of the first inorganic encapsulation area IEA1 in the second direction DR2.

Then, the cutting unit CU inserted into the second insertion area INSA2 may cut the first organic layer OL1 adjacent to the support substrate SSUB along the first inorganic encapsulation area IEA1. In this case, the cutting unit CU inserted into the second insertion area INSA2 may cut the first organic layer OL1 from the upper left corner to the upper right corner of the first inorganic encapsulation area IEA1 in the first direction DR1 after the cutting unit CU cuts the first organic layer OL1 from the lower left corner to the upper left corner of the first inorganic encapsulation area IEA1 in the second direction DR2.

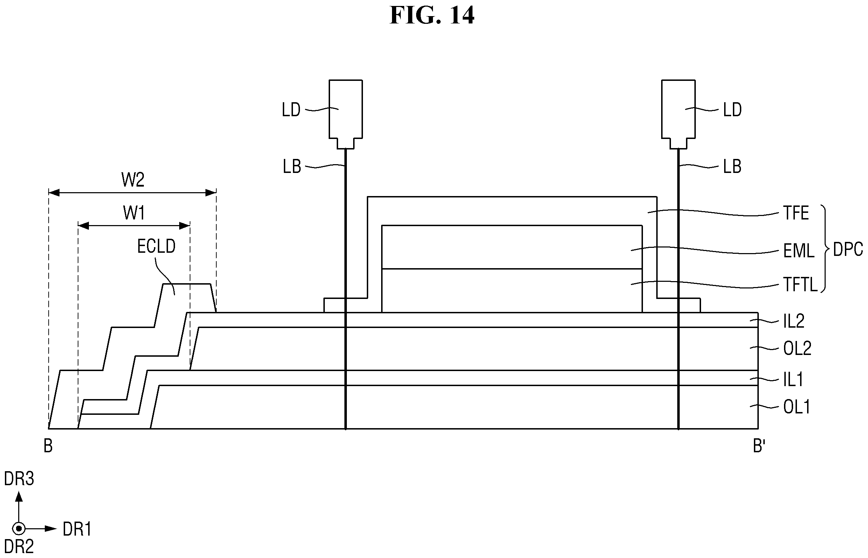

Fourth, as shown in FIG. 14, the plurality of display cells DPC of the mother substrate MSUB are cut to complete the plurality of display devices 10 (or display panels). (S400 in FIG. 10)

The plurality of display cells DPC of the mother substrate MSUB may be cut using a laser LB of the laser device LD or a cutting unit. The plurality of display devices may have a structure in which the first organic layer OL1, the first inorganic layer IL1, the second organic layer OL2, the second inorganic layer IL2, the thin film transistor layer TFTL, the light emitting element layer EML and the encapsulation layer TFE are sequentially stacked.

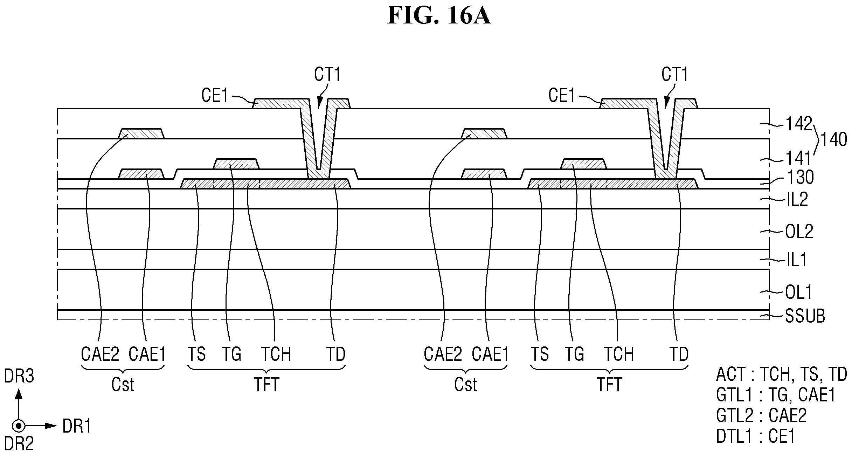

FIG. 15 is a flowchart illustrating a forming method of a plurality of display cells and an encapsulation cover layer according to one or more embodiments. FIGS. 16a, 16b, 17a, 17b, 18a, and 18b are cross-sectional views illustrating a forming method of a plurality of display cells and an encapsulation cover layer according to one or more embodiments. Hereinafter, in conjunction with FIGS. 15, 16a, 16b, 17a, 17b, 18a, and 18b, forming the plurality of display cells DPC and the encapsulation cover layer ECLD on the second inorganic layer IL2 according to an operation S200 will be described in more detail.

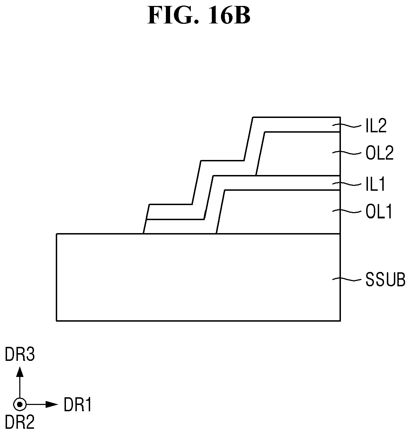

First, the plurality of thin film transistors TFT are formed on the second inorganic layer IL2 as shown in FIGS. 16a and 16b. (S210 of FIG. 15)

First of all, the active layer ACT including the channel TCH, the first electrode TS, and the second electrode TD of each of the plurality of thin film transistors TFTs is formed on the second inorganic layer IL2. The active layer ACT may be formed of a silicon semiconductor such as polycrystalline silicon, single crystal silicon, and low-temperature polycrystalline silicon, or an oxide semiconductor.

Then, the gate insulating layer 130 is formed on the active layer ACT. The gate insulating layer 130 may be formed of an inorganic layer, for example, a silicon nitride layer, a silicon oxynitride layer, a silicon oxide layer, a titanium oxide layer, or an aluminium oxide layer.

Then, the first gate layer GTL1 including the gate electrode TG of each of the plurality of thin film transistors TFT and the first capacitor electrode CAE1 of each of the capacitors Cst may be formed on the gate insulating layer 130. The gate electrode TG may overlap the channel TCH in the third direction DR3. The first gate layer GTL1 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

Then, the first interlayer insulating layer 141 is formed on the first gate layer GTL1. The first interlayer insulating layer 141 may be formed of an inorganic layer, for example, a silicon nitride layer, a silicon oxynitride layer, a silicon oxide layer, a titanium oxide layer, or an aluminium oxide layer.

Then, the second gate layer GTL2 including the second capacitor electrode CAE2 of each of the capacitors Cst is formed on the first interlayer insulating layer 141. The second capacitor electrode CAE2 may overlap the first capacitor electrode CAE1 in the third direction DR3. The second gate layer GTL2 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

Then, the second interlayer insulating layer 142 is formed on the second gate layer GTL2. The second interlayer insulating layer 142 may be formed of an inorganic layer, for example, a silicon nitride layer, a silicon oxynitride layer, a silicon oxide layer, a titanium oxide layer, or an aluminium oxide layer.

Then, the first data metal layer DTL1 including the first connection electrode CE1 is formed on the second interlayer insulating layer 142. The first connection electrode CE1 may be connected to the first electrode TS or the second electrode TD of the thin film transistor TFT through the first contact hole CT1 penetrating the gate insulating layer 130, the first interlayer insulating layer 141, and the second interlayer insulating layer 142. The first data metal layer DTL1 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

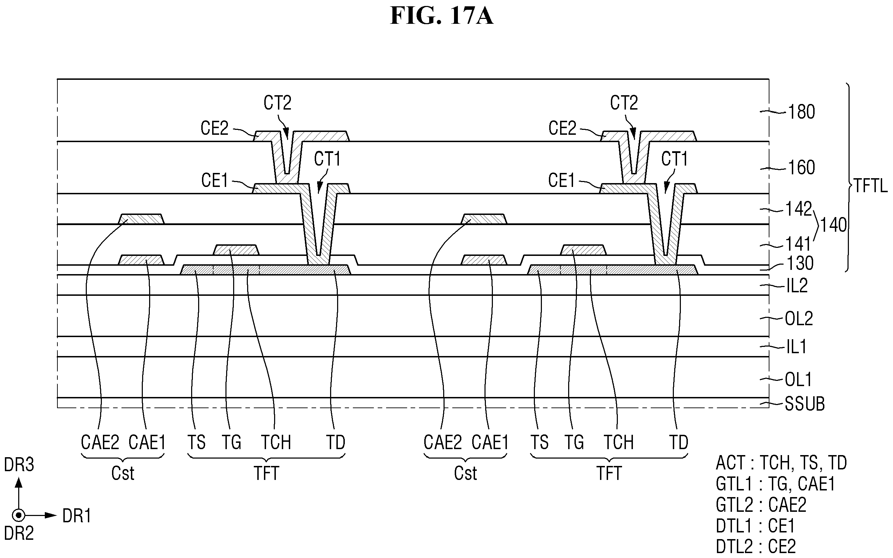

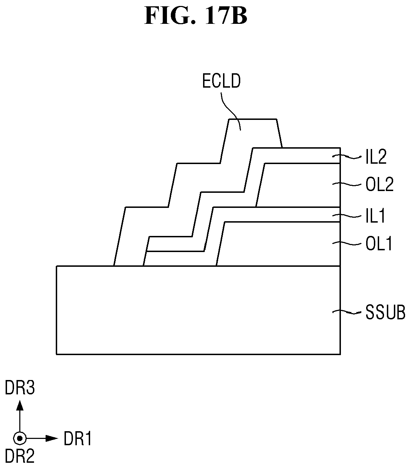

Second, as shown in FIGS. 17a and 17b, at least one planarization layer 160 and 180 covering the plurality of thin film transistors TFT and an encapsulation cover layer ECLD covering the first inorganic encapsulation area IEA1 are simultaneously or concurrently formed. (S220 in FIG. 15)

First of all, the first planarization layer 160 covering the plurality of thin film transistors TFT is formed. The first planarization layer 160 may be formed on the first data metal layer DTL1. The first planarization layer 160 may be formed of an organic film such as acrylic resin, epoxy resin, phenolic resin, polyamide resin, polyimide resin, etc.

Then, the second data metal layer DTL2 including the second connection electrode CE2 is formed on the first planarization layer 160. The second connection electrode CE2 may be connected to the first connection electrode CE1 through the second contact hole CT2 penetrating the first planarization layer 160. The second data metal layer DTL2 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

Then, the second planarization layer 180 is formed on the second data metal layer DTL2. The second planarization layer 180 may be formed of an organic film such as acrylic resin, epoxy resin, phenolic resin, polyamide resin, polyimide resin, etc.

The encapsulation cover layer ECLD covering the first inorganic encapsulation area IEA1 may be formed simultaneously or concurrently with the first planarization layer 160. In this case, the encapsulation cover layer ECLD may include the same organic material as the first planarization layer 160.

Alternatively, the encapsulation cover layer ECLD covering the first inorganic encapsulation area IEA1 may be formed simultaneously or concurrently with the second planarization layer 180. In this case, the encapsulation cover layer ECLD may include the same organic material as the second planarization layer 180.

The encapsulation cover layer ECLD may be formed on the side surface of the first inorganic layer IL1 and the top and side surfaces of the second inorganic layer IL2. In addition, the encapsulation cover layer ECLD may be formed on the first surface of the support substrate SSUB that is not covered by the first inorganic layer IL1 and is exposed.

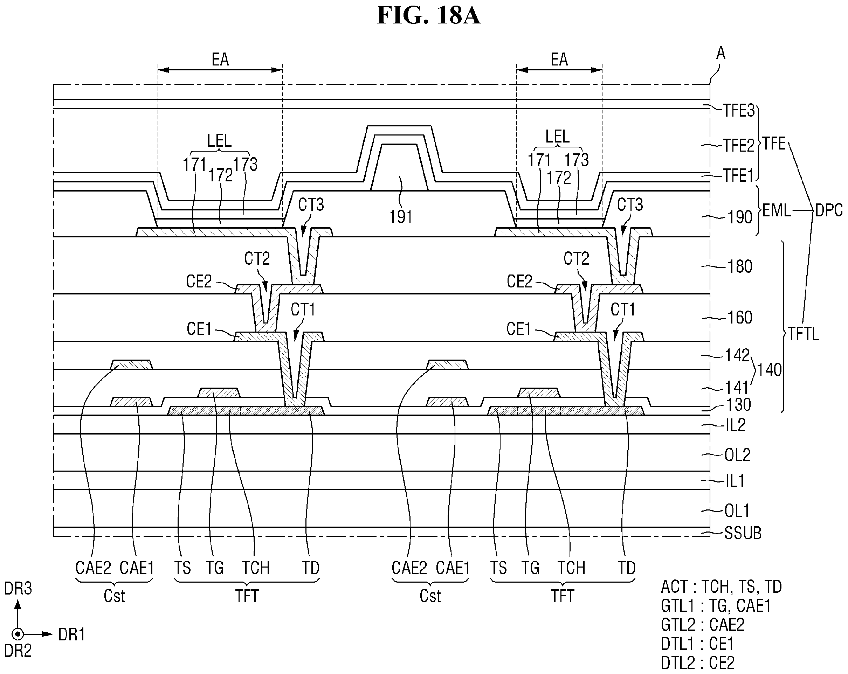

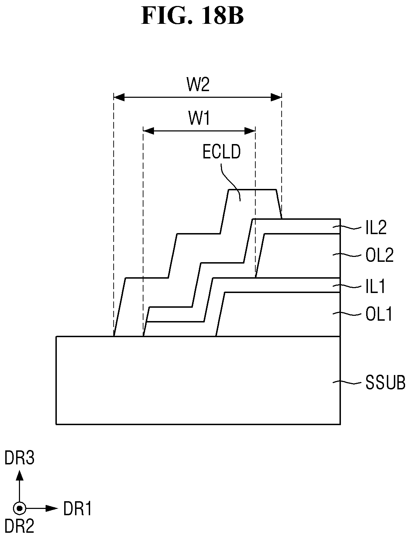

Third, as shown in FIGS. 18a and 18b, the plurality of light emitting elements LEL are formed on at least one planarization layer 160 and 180, and the encapsulation film TFE for encapsulating the plurality of light emitting elements LEL are formed. (S230 in FIG. 15)

First of all, the pixel electrode 171 of each of the plurality of light emitting elements LEL is formed on the second planarization layer 180. The pixel electrode 171 of each of the plurality of light emitting elements LEL may be connected to the second connection electrode CE2 through the third contact hole CT3 penetrating the second planarization layer 180. The pixel electrode 171 of each of the plurality of light emitting elements LEL may be formed of a metal material having a high reflectance such as a layered structure of aluminium and titanium (Ti/Al/Ti), a layered structure of aluminium and ITO (Indium Tin Oxide) (ITO/AI/ITO), APC alloy, and a layered structure of APC alloy and ITO (ITO/APC/ITO). The APC alloy is an alloy of silver (Ag), palladium (Pd), and copper (Cu).

Then, the bank 190 is formed to cover the edge of the pixel electrode 171 of each of the plurality of light emitting elements LEL to define the plurality of light emitting units EA. The bank 190 may be formed of an organic layer such as an acrylic resin, an epoxy resin, a phenolic resin, a polyamide resin, or a polyimide resin.

Then, a spacer 191 is formed on the bank 190. The spacer 191 may serve to support the mask during the process of manufacturing the light emitting layer 172. The spacer 191 may be formed of an organic layer such as an acrylic resin, an epoxy resin, a phenolic resin, a polyamide resin, or a polyimide resin.

Then, the light emitting layer 172 is formed on the pixel electrode 171 in each of the plurality of light emitting units EA. The the light emitting layer 172 may include an organic material to emit a color (e.g., a set or predetermined color). For example, the light emitting layer 172 may include the hole transporting layer, the organic material layer, and the electron transporting layer.

Then, the common electrode 173 is formed on the light emitting layer 172 and the bank 190. The common electrode 173 may be arranged to cover the light emitting layer 172 and the bank 190. The common electrode 173 may be a common layer commonly formed in the plurality of light emitting units EA. The common electrode 173 may be formed of a Transparent Conductive Oxide (TCO) such as ITO or IZO that may transmit light, or a semi-transmissive conductive material such as magnesium (Mg), silver (Ag), or an alloy of magnesium (Mg) and silver.

Then, an encapsulation layer TFE is formed on the common electrode 173. For example, the first encapsulation inorganic layer TFE1 is formed on the common electrode 173, the encapsulation organic layer TFE2 is formed on the first encapsulation inorganic layer TFE1, and the second encapsulation inorganic layer TFE3 is formed on the encapsulation organic layer TFE2. The first encapsulation inorganic layer TFE1 and the second encapsulation inorganic layer TFE3 may be formed as a multilayer in which one or more inorganic layers of silicon nitride layer, silicon oxynitride layer, silicon oxide layer, titanium oxide layer, and aluminium oxide layer are alternately stacked. The encapsulation organic layer TFE2 may be an organic film such as an acrylic resin, an epoxy resin, a phenolic resin, a polyamide resin, or a polyimide resin.

As shown FIGS. 15, 16a, 16b, 17a, 17b, 18a, and 18b, there is no need to add a separate process for forming the encapsulation cover layer ECLD by simultaneously or concurrently forming at least one planarization layer 160 and 180 and the encapsulation cover layer ECLD. In addition, because it may be possible to prevent or reduce damage to the first inorganic encapsulation area IEA1 due to physical contact with the manufacturing equipment during the manufacturing process and high-pressure injection of the cleaning liquid of the cleaning equipment due to the encapsulation cover layer ECLD, it may be possible to prevent a portion of the first inorganic layer IL1 and the second inorganic layer IL2 of the first inorganic encapsulation area IEA1 from falling off.

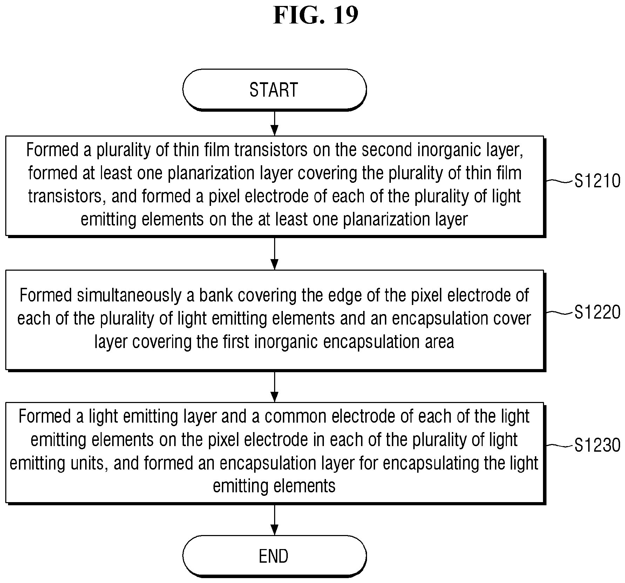

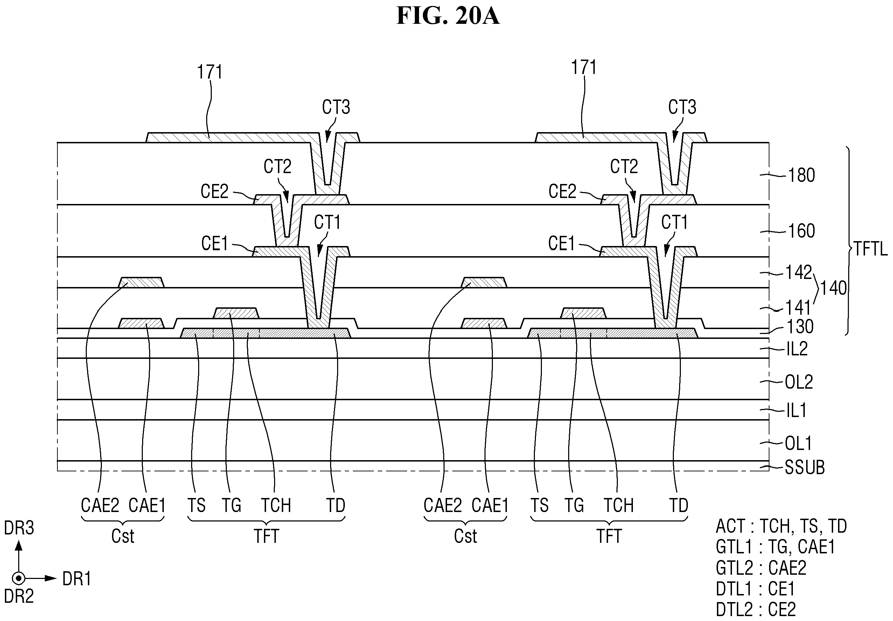

FIG. 19 is a flowchart illustrating a forming method of a plurality of display cells and an encapsulation cover layer according to one or more embodiments. FIGS. 20a, 20b, 21a, 21b, 22a, and 22b are cross-sectional views illustrating a forming method of a plurality of display cells and an encapsulation cover layer according to one or more embodiments. Hereinafter, in conjunction with FIGS. 19, 20a, 20b, 21a, 21b, 22a, and 22b, the step of forming the plurality of display cells DPC and the encapsulation cover layer ECLD on the second inorganic layer IL2 (S200) according to some embodiments will be described in more detail.

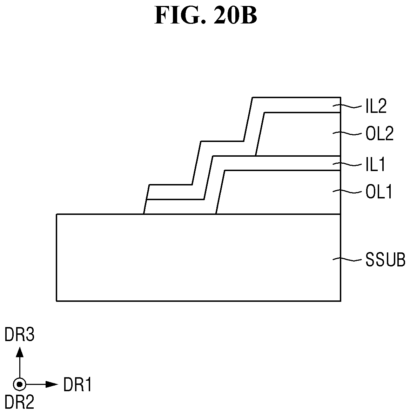

First, as shown in FIGS. 20a and 20b, the plurality of thin film transistors TFT are formed on the second inorganic layer IL2 and at least one planarization layer 160 and 180 covering the plurality of thin film transistors TFT and the first electrode 171 of each of the plurality of light emitting elements LEL is formed on at least one planarization layer 160 and 180. (S1210 in FIG. 19)

First of all, an active layer ACT including the channel TCH, the first electrode TS, and the second electrode TD of each of the plurality of thin film transistors TFT is formed on the second inorganic layer IL2.

Then, the gate insulating layer 130 is formed on the active layer ACT.

Then, the first gate layer GTL1 including the gate electrode TG of each of the plurality of thin film transistors TFT and the first capacitor electrode CAE1 of each of the capacitors Cst is formed on the gate insulating layer 130.

Then, the first interlayer insulating layer 141 is formed on the first gate layer GTL1.

Then, the second gate layer GTL2 including the second capacitor electrode CAE2 of each of the capacitors Cst is formed on the first interlayer insulating layer 141.

Then, the second interlayer insulating layer 142 is formed on the second gate layer GTL2.

Then, the first data metal layer DTL1 including the first connection electrode CE1 is formed on the second interlayer insulating layer 142. The first connection electrode CE1 may be connected to the first electrode TS or the second electrode TD of the thin film transistor TFT through the first contact hole CT1 penetrating the gate insulating layer 130, the first interlayer insulating layer 141, and the second interlayer insulating layer 142.

Then, the first planarization layer 160 covering the plurality of thin film transistors TFT is formed.

Then, the second data metal layer DTL2 including the second connection electrode CE2 is formed on the first planarization layer 160. The second connection electrode CE2 may be connected to the first connection electrode CE1 through the second contact hole CT2 penetrating the first planarization layer 160.

Then, the second planarization layer 180 is formed on the second data metal layer DTL2.

Then, the pixel electrode 171 of each of the plurality of light emitting elements LEL is formed on the second planarization layer 180. The pixel electrode 171 of each of the plurality of light emitting elements LEL may be connected to the second connection electrode CE2 through the third contact hole CT3 penetrating the second planarization layer 180.

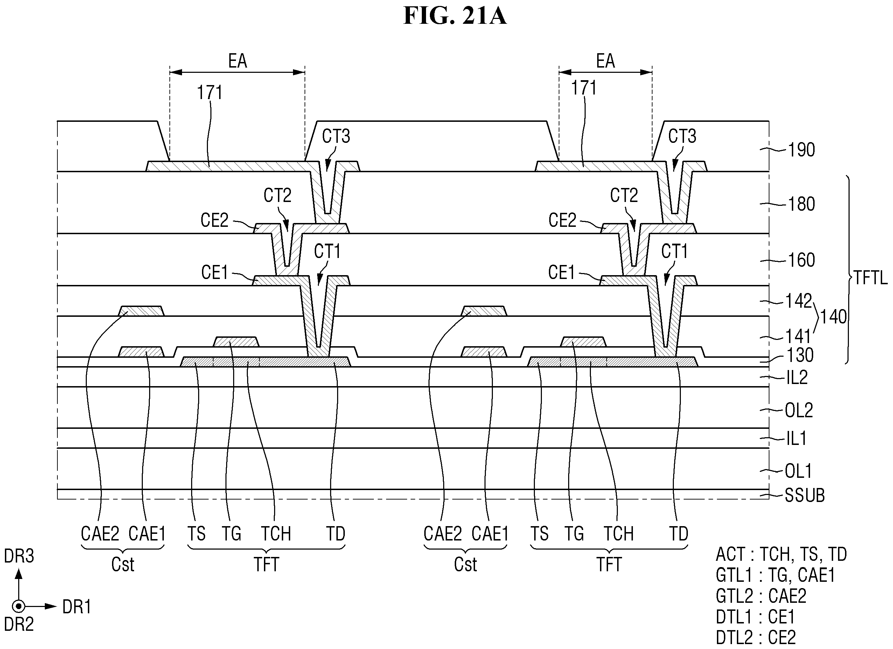

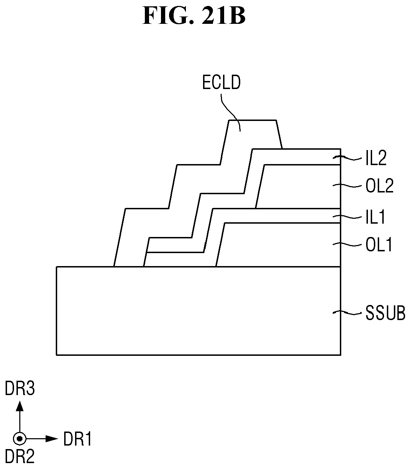

Second, as shown in FIGS. 21a and 21b, the bank 190 covering the edge of the first electrode 171 of each of the plurality of light emitting elements LEL and the encapsulation cover layer ECLD covering the first inorganic encapsulation area IEA1 are simultaneously or concurrently formed. (S1220 in FIG. 19)

The bank 190 is formed to cover the edge of each of the pixel electrodes 171 of the plurality of light emitting elements LEL to define the plurality of light emitting units EA. The bank 190 may be formed of an organic layer such as an acrylic resin, an epoxy resin, a phenolic resin, a polyamide resin, or a polyimide resin.

The encapsulation cover layer ECLD covering the first inorganic encapsulation area IEA1 may be formed simultaneously or concurrently with the bank 190. In this case, the encapsulation cover layer ECLD may include the same organic material as the bank 190.

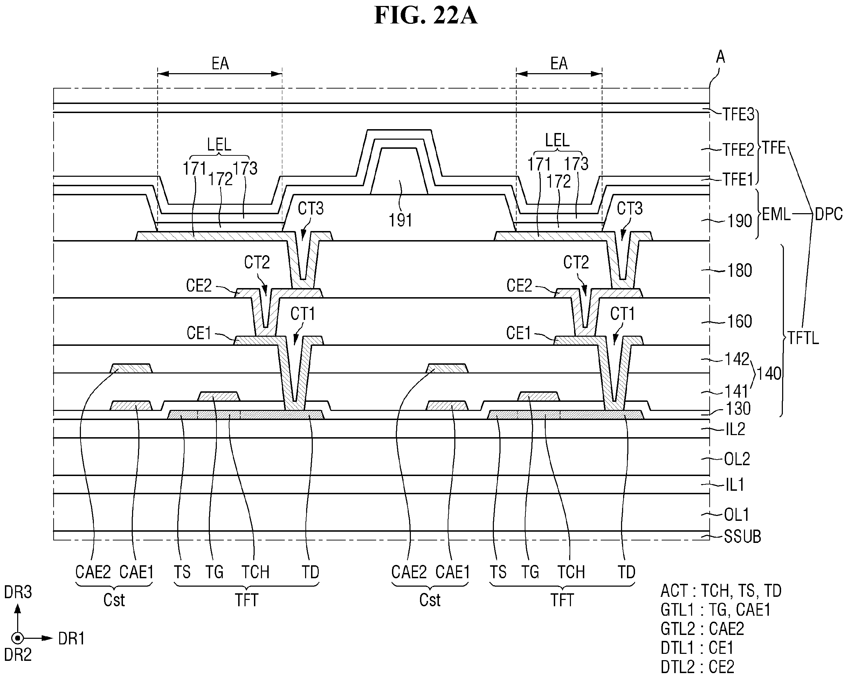

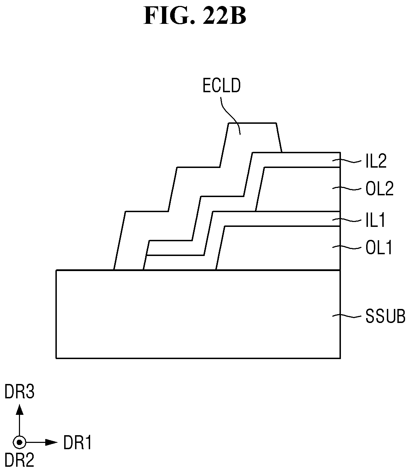

Third, as shown in FIGS. 22a and 22b, the light emitting layer 172 and the common electrode 173 of each of the light emitting elements are formed on the pixel electrode 171 in each of the plurality of light emitting units EA, and the encapsulation layer TFE for encapsulating the light emitting element is formed. (S1230 of FIG. 19)

First of all, the spacer 191 is formed on the bank 190. The spacer 191 may serve to support the mask during the process of manufacturing the light emitting layer 172.

Then, the light emitting layer 172 is formed on the pixel electrode 171 in each of the plurality of light emitting units EA.

Then, the common electrode 173 is formed on the light emitting layer 172 and the bank 190. The common electrode 173 may be a common layer commonly formed in the plurality of light emitting units EA.

Then, the encapsulation layer TFE is formed on the common electrode 173. For example, the first encapsulation inorganic layer TFE1 is formed on the common electrode 173, the encapsulation organic layer TFE2 is formed on the first encapsulation inorganic layer TFE1, and the second encapsulation inorganic layer TFE3 is formed on the encapsulation organic layer TFE2.

As shown in FIGS. 19, 20a, 20b, 21a, 21b, 22a and 22b, there is no need to add a separate process for forming the encapsulation cover layer ECLD by simultaneously or concurrently forming the bank layer 190 and the encapsulation cover layer ECLD. In addition, because it may be possible to prevent or reduce damage to the first inorganic encapsulation area IEA1 due to physical contact with the manufacturing equipment during the manufacturing process and high-pressure injection of the cleaning liquid of the cleaning equipment due to the encapsulation cover layer ECLD, it may be possible to prevent or reduce instances of a portion of the first inorganic layer IL1 and the second inorganic layer IL2 of the first inorganic encapsulation area IEA1 falling off.

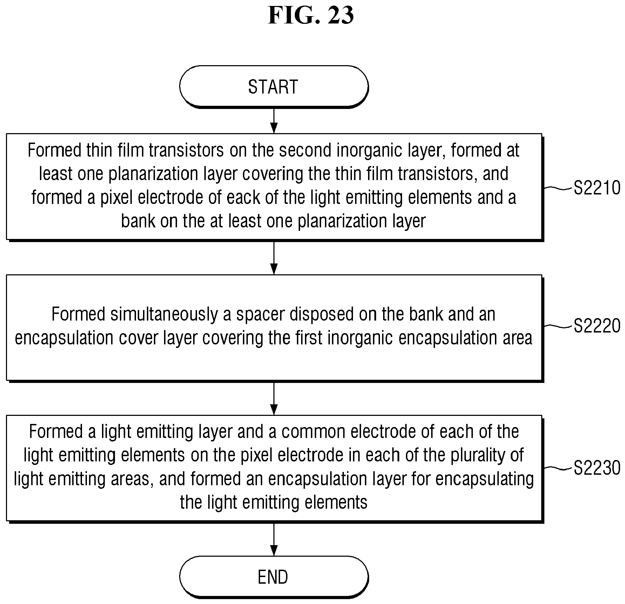

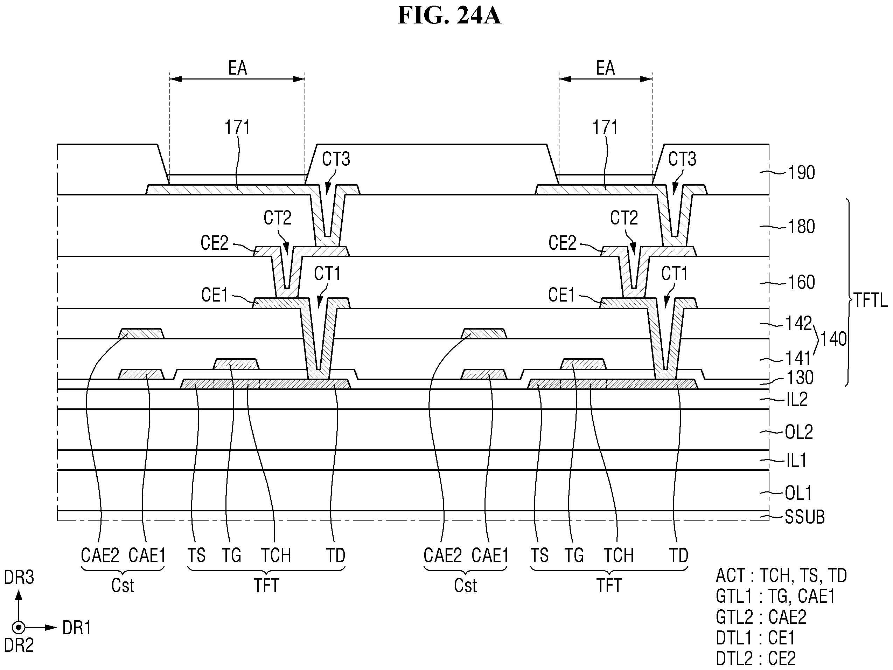

FIG. 23 is a flowchart illustrating a forming method of a plurality of display cells and an encapsulation cover layer according to some embodiments. FIGS. 24a, 24b, 25a, 25b, 26a, and 26b are cross-sectional views illustrating a plurality of display cells and a forming method of an encapsulation cover layer according to some embodiments. Hereinafter, in conjunction with FIGS. 23, 24a, 24b, 25a, 25b, 26a, and 26b, the step of forming the plurality of display cells DPC and the encapsulation cover layer ECLD on the second inorganic layer IL2 (S200) according to some embodiments will be described in more detail.

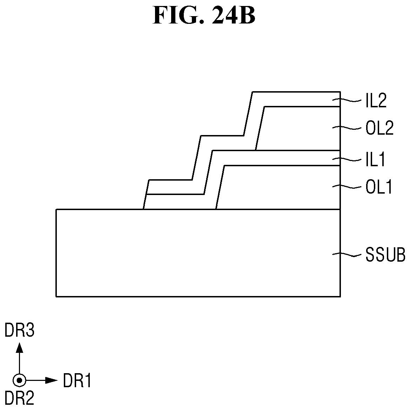

First, as shown in FIGS. 24a and 24b, the plurality of thin film transistors TFT are formed on the second inorganic layer IL2 and at least one planarization layer 160 and 180 covering the plurality of thin film transistors TFT, and the first electrode 171 and the bank 190 of each of the plurality of light emitting elements LEL are formed on at least one planarization layer 160 and 180. (S2210 in FIG. 23)

First of all, the active layer ACT including the channel TCH, the first electrode TS, and the second electrode TD of each of the plurality of thin film transistors TFT is formed on the second inorganic layer IL2.

Then, the gate insulating layer 130 is formed on the active layer ACT.

Then, the first gate layer GTL1 including the gate electrode TG of each of the plurality of thin film transistors TFT and the first capacitor electrode CAE1 of each of the capacitors Cst is formed on the gate insulating layer 130.

Then, the first interlayer insulating layer 141 is formed on the first gate layer GTL1.

Then, the second gate layer GTL2 including the second capacitor electrode CAE2 of each of the capacitors Cst is formed on the first interlayer insulating layer 141.

Then, the second interlayer insulating layer 142 is formed on the second gate layer GTL2.

Then, the first data metal layer DTL1 including the first connection electrode CE1 is formed on the second interlayer insulating layer 142. The first connection electrode CE1 may be connected to the first electrode TS or the second electrode TD of the thin film transistor TFT through the first contact hole CT1 penetrating the gate insulating layer 130, the first interlayer insulating layer 141, and the second interlayer insulating layer 142.

Then, the first planarization layer 160 covering the plurality of thin film transistors TFT is formed.

Then, the second data metal layer DTL2 including the second connection electrode CE2 is formed on the first planarization layer 160. The second connection electrode CE2 may be connected to the first connection electrode CE1 through the second contact hole CT2 penetrating the first planarization layer 160.

Then, the second planarization layer 180 is formed on the second data metal layer DTL2.

Then, the pixel electrode 171 of each of the plurality of light emitting elements LEL is formed on the second planarization layer 180. The pixel electrode 171 of each of the plurality of light emitting elements LEL may be connected to the second connection electrode CE2 through the third contact hole CT3 penetrating the second planarization layer 180.

Then, the bank 190 is formed to cover the edge of the pixel electrode 171 of each of the plurality of light emitting elements LEL to define the plurality of light emitting units EA.

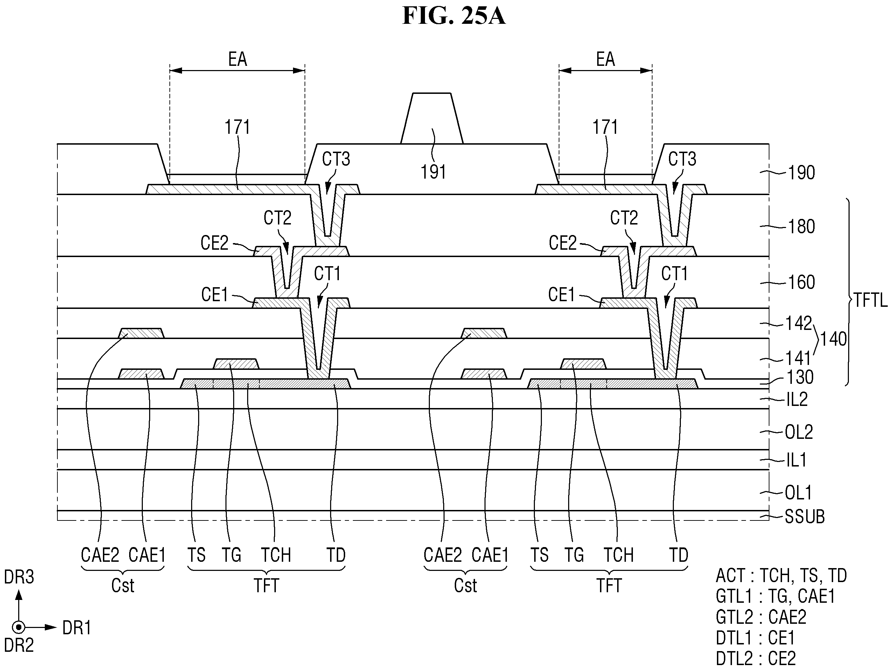

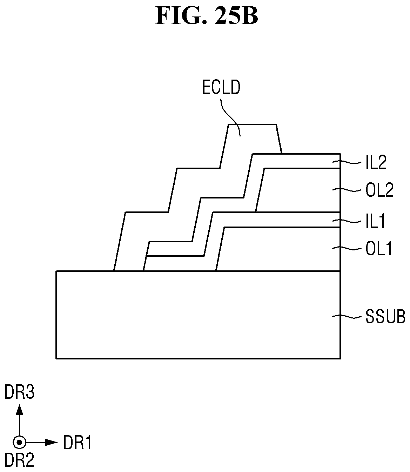

Second, as shown in FIGS. 25a and 25b, the spacer 191 located on the bank 190 and the encapsulation cover layer ECLD covering the first inorganic encapsulation area IEA1 are simultaneously or concurrently formed. (S2220 in FIG. 23)

The spacer 191 is formed on the bank 190. The spacer 191 may serve to support the mask during the process of manufacturing the light emitting layer 172. The spacer 191 may be formed of an organic layer such as an acrylic resin, an epoxy resin, a phenolic resin, a polyamide resin, or a polyimide resin.

The encapsulation cover layer ECLD covering the first inorganic encapsulation area IEA1 may be formed simultaneously or concurrently with the spacer 191. In this case, the encapsulation cover layer ECLD may include the same organic material as the spacer 191.

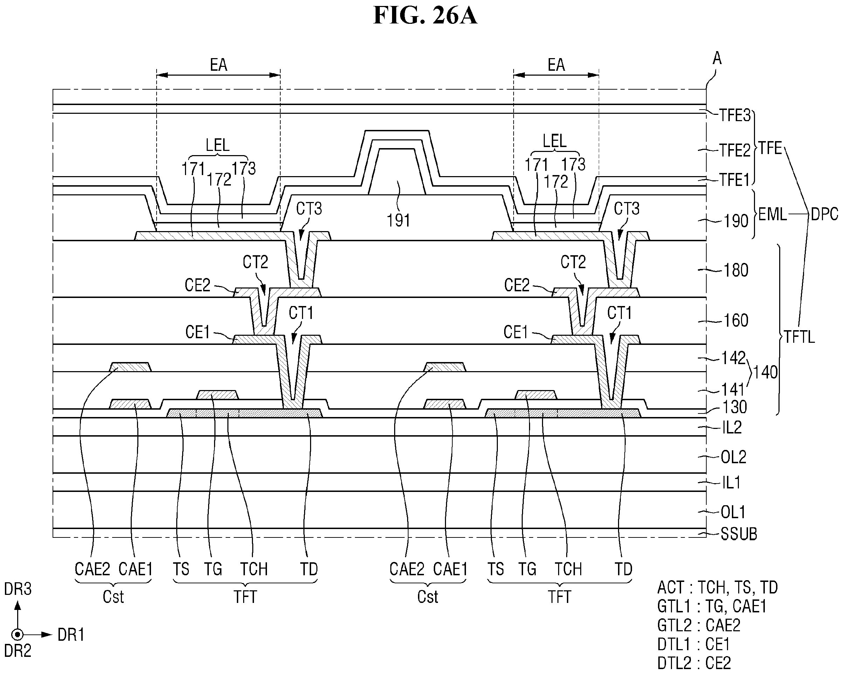

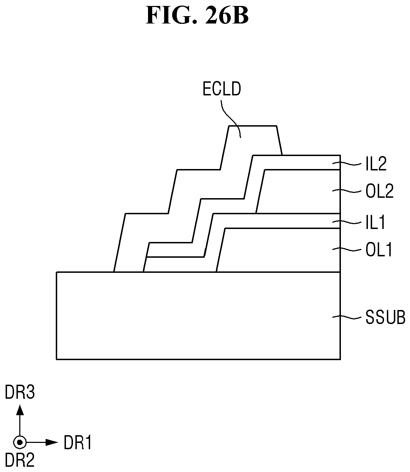

Third, as shown in FIGS. 26a and 26b, the light emitting layer 172 and the common electrode 173 of each of the light emitting elements are formed on the pixel electrode 171 in each of the plurality of light emitting units EA, and the encapsulation layer for encapsulating the light emitting elements is formed. (S2230 in FIG. 23)

First of all, the light emitting layer 172 is formed on the pixel electrode 171 in each of the plurality of light emitting units EA.

Then, the common electrode 173 is formed on the light emitting layer 172 and the bank 190. The common electrode 173 may be a common layer commonly formed in the plurality of light emitting units EA.

Then, the encapsulation layer TFE is formed on the common electrode 173. For example, the first encapsulation inorganic layer TFE1 is formed on the common electrode 173, the encapsulation organic layer TFE2 is formed on the first encapsulation inorganic layer TFE1, and the second encapsulation inorganic layer TFE3 is formed on the encapsulation organic layer TFE2.

As shown in FIGS. 23, 24a, 24b, 25a, 25b, 26a, and 26b, there is no need to add a separate process for forming the encapsulation cover layer ECLD by simultaneously or concurrently forming the spacer 191 and the encapsulation cover layer ECLD. In addition, because it may be possible to prevent or reduce damage to the first inorganic encapsulation area IEA1 due to physical contact with the manufacturing equipment during the manufacturing process and high-pressure injection of the cleaning liquid of the cleaning equipment due to the encapsulation cover layer ECLD, it may be possible to prevent or reduce instances of a portion of the first inorganic layer IL1 and the second inorganic layer IL2 of the first inorganic encapsulation area IEA1 falling off.

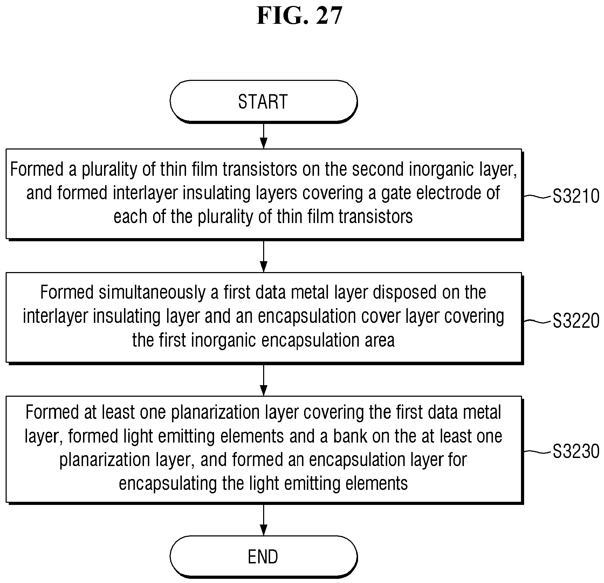

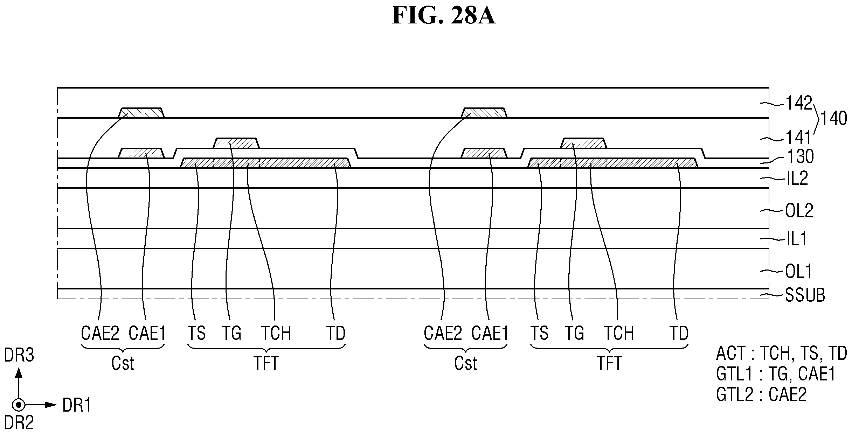

FIG. 27 is a flowchart illustrating a forming method of a plurality of display cells and an encapsulation cover layer according to some embodiments. FIGS. 28a, 28b, 29a, 29b, 30a, and 30b are cross-sectional views illustrating a plurality of display cells and a forming method of an encapsulation cover layer according to some embodiments. Hereinafter, in conjunction with FIGS. 27, 28a, 28b, 29a, 29b, 30a, and 30b, the step of forming the plurality of display cells DPC and the encapsulation cover layer ECLD on the second inorganic layer IL2 (S200) according to some embodiments will be described in more detail.

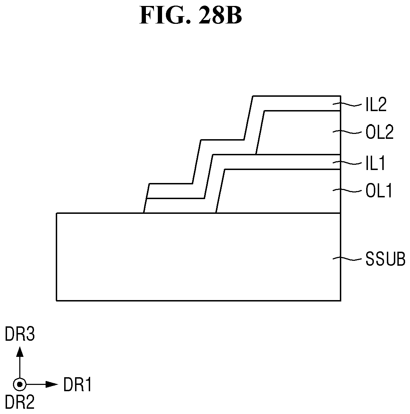

First, as shown in FIGS. 28a and 28b, the plurality of thin film transistors TFT are formed on the second inorganic layer IL2, and the interlayer insulating layer 141 covering the gate electrodes of each of the plurality of thin film transistors TFT is formed. (S3210 in FIG. 27)

First of all, the active layer ACT including the channel TCH, the first electrode TS, and the second electrode TD of each of the plurality of thin film transistors TFT is formed on the second inorganic layer IL2.

Then, the gate insulating layer 130 is formed on the active layer ACT.

Then, the first gate layer GTL1 including the gate electrode TG of each of the plurality of thin film transistors TFT and the first capacitor electrode CAE1 of each of the capacitors Cst is formed on the gate insulating layer 130.

Then, the first interlayer insulating layer 141 is formed on the first gate layer GTL1.

Then, the second gate layer GTL2 including the second capacitor electrode CAE2 of each of the capacitors Cst is formed on the first interlayer insulating layer 141.

Then, the second interlayer insulating layer 142 is formed on the second gate layer GTL2.

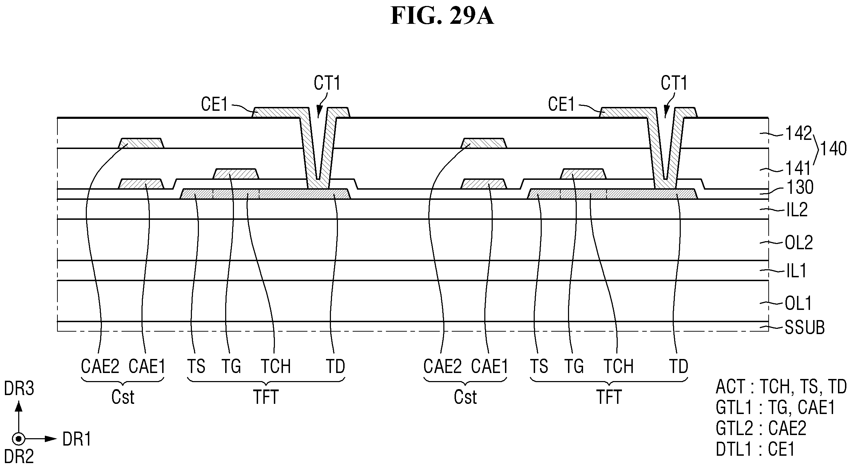

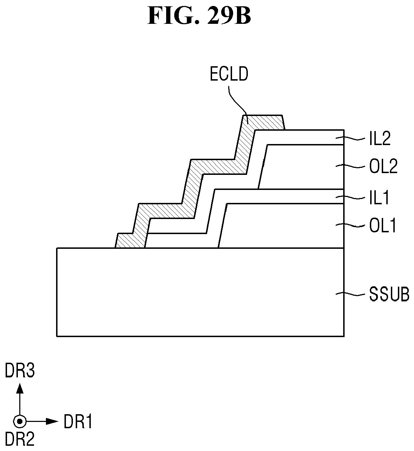

Second, as shown in FIGS. 29a and 29b, the first data metal layer DTL1 located on the interlayer insulating layers 141 and 142 and the encapsulation cover layer ECLD covering the first inorganic encapsulation area IEA1 are simultaneously or concurrently formed. (S3220 in FIG. 27)

The first data metal layer DTL1 including the first connection electrode CE1 is formed on the second interlayer insulating layer 142. The first connection electrode CE1 may be connected to the first electrode TS or the second electrode TD of the thin film transistor TFT through the first contact hole CT1 penetrating the gate insulating layer 130, the first interlayer insulating layer 141, and the second interlayer insulating layer 142. The first data metal layer DTL1 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The encapsulation cover layer ECLD covering the first inorganic encapsulation area IEA1 may be formed simultaneously or concurrently with the first data metal layer DTL1. In this case, the encapsulation cover layer ECLD may include the same organic material as the first data metal layer DTL1.

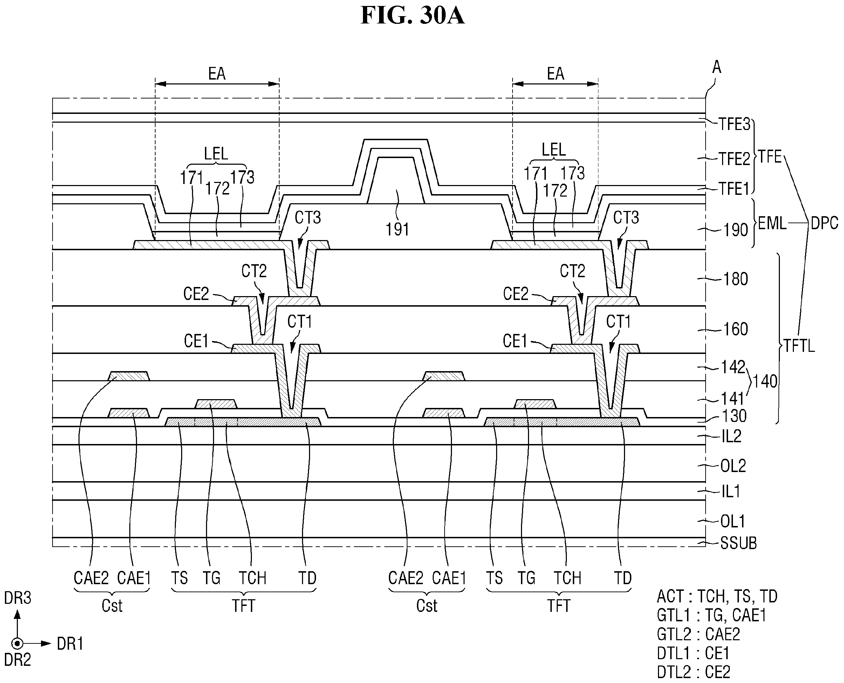

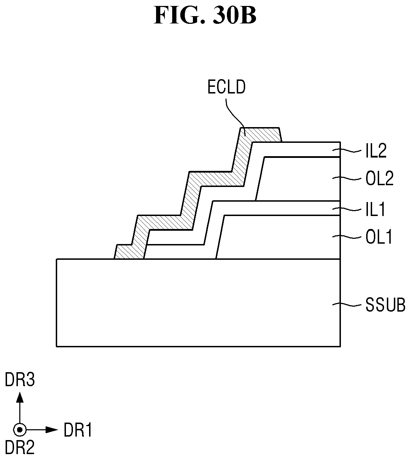

Third, as shown in FIGS. 30a and 30b, at least one planarization layer 160 and 180 covering the first data metal layer DTL1 is formed, the light emitting elements LEL and the bank 190 are formed on the at least one planarization layer 160 and 180, and the encapsulation layer TFE for encapsulating the light emitting elements LEL is formed. (S3230 in FIG. 27)

First of all, the first planarization layer 160 is formed on the first data metal layer DTL1.

The second data metal layer DTL2 including the second connection electrode CE2 is formed on the first planarization layer 160. The second connection electrode CE2 may be connected to the first connection electrode CE1 through the second contact hole CT2 penetrating the first planarization layer 160.

Then, the second planarization layer 180 is formed on the second data metal layer DTL2.

Then, the pixel electrode 171 of each of the plurality of light emitting elements LEL is formed on the second planarization layer 180. The pixel electrode 171 of each of the plurality of light emitting elements LEL may be connected to the second connection electrode CE2 through the third contact hole CT3 penetrating the second planarization layer 180.

Then, the bank 190 is formed to cover the edge of the pixel electrode 171 of each of the plurality of light emitting elements LEL to define the plurality of light emitting units EA.

Then, the spacer 191 is formed on the bank 190. The spacer 191 may serve to support the mask during the process of manufacturing the light emitting layer 172.

Then, the light emitting layer 172 is formed on the pixel electrode 171 in each of the plurality of light emitting units EA.

Then, the common electrode 173 is formed on the light emitting layer 172 and the bank 190. The common electrode 173 may be a common layer commonly formed in the plurality of light emitting units EA.

Then, the encapsulation layer TFE is formed on the common electrode 173. For example, the first encapsulation inorganic layer TFE1 is formed on the common electrode 173, the encapsulation organic layer TFE2 is formed on the first encapsulation inorganic layer TFE1, and the second encapsulation inorganic layer TFE3 is formed on the encapsulation organic layer TFE2.

As shown in FIGS. 27, 28a, 28b, 29a, 29b, 30a, and 30b, there is no need to add a separate process for forming the encapsulation cover layer ECLD by simultaneously or concurrently forming the first data metal layer DTL1 and the encapsulation cover layer ECLD. In addition, because it may be possible to prevent or reduce damage to the first inorganic encapsulation area IEA1 due to physical contact with the manufacturing equipment during the manufacturing process and high-pressure injection of the cleaning liquid of the cleaning equipment due to the encapsulation cover layer ECLD, it may be possible to prevent a portion of the first inorganic layer IL1 and the second inorganic layer IL2 of the first inorganic encapsulation area IEA1 from falling off.

In addition, FIGS. 27, 28a, 28b, 29a, 29b, 30a, and 30b illustrate that the encapsulation cover layer ECLD is formed simultaneously or concurrently with the first data metal layer DTL1, but the embodiments of the present disclosure are not limited thereto. For example, the encapsulation cover layer ECLD may be formed of the same metal material as any one of the first gate metal layer GTL1, the second gate metal layer GTL2, the second data metal layer DTL2, and the pixel electrode 171.

However, the aspects of embodiments of the present disclosure are not restricted to the one set forth herein. The above and other aspects of the present disclosure will become more apparent to one of daily skill in the art to which the present disclosure pertains by referencing the claims, with functional equivalents thereof to be included therein.

## Claims

1. A mother substrate comprising:
a support substrate;
a first organic layer on one surface of the support substrate;
a first inorganic layer on the first organic layer and covering an edge of the first organic layer;
a second organic layer on the first inorganic layer;
a second inorganic layer on the second organic layer and covering an edge of the second organic layer;
a plurality of display cells on the second inorganic layer; and
an encapsulation cover layer on a first inorganic encapsulation area in which the first inorganic layer and the second inorganic layer are in contact with each other.

2. The mother substrate of claim 1, wherein the encapsulation cover layer covers an entirety of the first inorganic encapsulation area.

3. The mother substrate of claim 1, wherein a portion of the first inorganic encapsulation area is exposed without being covered by the encapsulation cover layer.

4. The mother substrate of any one of claims 1 to 3, wherein a width of the encapsulation cover layer is greater than a width of the first inorganic encapsulation area.

5. The mother substrate of any one of claims 1 to 4, wherein each of the plurality of display cells comprises:
a plurality of thin film transistors on the second inorganic layer;
at least one planarization layer on the plurality of thin film transistors;
a plurality of light emitting elements on the at least one planarization layer; and
an encapsulation layer encapsulating the plurality of light emitting elements, and
wherein each of the plurality of thin film transistors includes an active layer and a gate electrode, and
wherein each of the plurality of light emitting elements includes a first electrode, a light emitting layer, and a second electrode.

6. The mother substrate of claim 5, wherein:
(i) the encapsulation cover layer and the at least one planarization layer include a same organic material; or
(ii) each of the plurality of display cells further comprises a bank covering an edge of the first electrode of each of the plurality of light emitting elements, and
wherein the encapsulation cover layer and the bank include a same organic material; or
(iii) each of the plurality of display cells further comprises a bank covering an edge of the first electrode of each of the plurality of light emitting elements, and a spacer on the bank, and
wherein the encapsulation cover layer and the spacer include a same organic material; or
(iv) each of the plurality of display cells further comprises:
a gate insulating layer between the active layer and the gate electrode;
an interlayer insulating layer on the gate electrode; and
a first connection electrode on the interlayer insulating layer and connected to the active layer through a contact hole penetrating the gate insulating layer and the interlayer insulating layer, and
wherein the encapsulation cover layer and the first connection electrode include a same metal material.

7. The mother substrate of claim 5 or claim 6, wherein the encapsulation layer comprises:
a first encapsulation inorganic layer on the second electrode of each of the light emitting elements;
an encapsulation organic layer on the first encapsulation inorganic layer;
a second encapsulation inorganic layer on the encapsulation organic layer; and
a second inorganic encapsulation area in which the second inorganic layer, the first encapsulation inorganic layer, and the second encapsulation inorganic layer are sequentially stacked surrounds each of the plurality of display cells.

8. The mother substrate of claim 1, wherein the encapsulation cover layer includes a metal material.

9. A method for fabricating a display device comprising:
sequentially forming a first organic layer, a first inorganic layer, a second organic layer, and a second inorganic layer on a support substrate;
forming a plurality of display cells and an encapsulation cover layer on the second inorganic layer;
separating the support substrate from the first organic layer;
cutting the plurality of display cells,
forming the plurality of display cells and the encapsulation cover layer on the second inorganic layer; and
forming the encapsulation cover layer on a first inorganic encapsulation area in which a first inorganic layer not covered by the second organic layer and the second inorganic layer contact each other.

10. The method for fabricating the display device of claim 9, wherein the encapsulation cover layer covers an entire first inorganic encapsulation area.

11. The method for fabricating the display device of claim 9, wherein a portion of the first inorganic encapsulation area is exposed without being covered by the encapsulation cover layer, optionally wherein the separating the support substrate from the first organic layer comprises:
inserting a cutting unit between the support substrate and the first organic layer in an insertion area where the first inorganic encapsulation area is exposed without being covered by the encapsulation cover layer; and
cutting between the support substrate and the first organic layer along the first inorganic encapsulation area with the cutting unit.

12. The method for fabricating the display device of any one of claims 9 to 11, wherein a width of the encapsulation cover layer is greater than a width of the first inorganic encapsulation area.

13. The method for fabricating the display device of any one of claims 9 to 12, wherein:
(i) the encapsulation cover layer is formed of an organic material; or
(ii) the encapsulation cover layer is formed of a metal material.

14. The method for fabricating the display device of any one of claims 9 to 12, further comprising:
forming the plurality of display cells and the encapsulation cover layer on the second inorganic layer,
forming a plurality of thin film transistors on the second inorganic layer;
simultaneously forming at least one planarization layer on the plurality of thin film transistors and the encapsulation cover layer of an organic material;
forming a plurality of light emitting elements on the at least one planarization layer; and
forming an encapsulation layer to encapsulate the plurality of light emitting elements.

15. The method for fabricating the display device of any one of claims 9 to 12, further comprising:
forming the plurality of display cells and the encapsulation cover layer on the second inorganic layer,
forming a plurality of thin film transistors on the second inorganic layer;
forming at least one planarization layer covering the plurality of thin film transistors, and forming a first electrode of each of a plurality of light emitting elements on the at least one planarization layer;
simultaneously forming a bank covering an edge of a first electrode of each of the plurality of light emitting elements and the encapsulation cover layer of an organic material;
forming a light emitting layer and a second electrode of each of the plurality of light emitting elements on the first electrode of each of the plurality of light emitting elements exposed without being covered by the bank; and
forming an encapsulation layer for encapsulating the plurality of light emitting elements.
